# EUROPÄISCHE PATENTSCHRIFT

(11) **EP 1 864 340 B1**
(45) Veröffentlichungstag und Bekanntmachung des Hinweises auf die Patenterteilung: **03.04.2019**
(21) Anmeldenummer: 06705997.2
(22) Anmeldetag: 21.02.2006
(51) Int. Cl.: H01L 33/48, H01L 33/58, F21V 5/04

(54) **BELEUCHTUNGSVORRICHTUNG**
ILLUMINATION DEVICE
DISPOSITIF D'ÉCLAIRAGE

(30) Priorität: 28.02.2005 DE 102005009067; 04.05.2005 DE 102005020908
(43) Veröffentlichungstag der Anmeldung: 12.12.2007
(60) Teilanmeldung: 10184176.5
(73) Patentinhaber: OSRAM Opto Semiconductors GmbH, 93055 Regensburg (DE)
(72) Erfinder: BLÜMEL, Simon, 84069 Schierling (DE); SCHELLHORN, Franz, 93049 Regensburg (DE); WAITL, Günter, 93049 Regensburg (DE); WANNINGER, Mario, 93055 Harting/Regensburg (DE)
(74) Vertreter: Epping - Hermann - Fischer
(86) Internationale Anmeldenummer: PCT/DE2006/000314
(87) Internationale Veröffentlichungsnummer: WO 2006/089523

(56) Entgegenhaltungen:
- EP-A- 1 227 458
- EP-A- 1 376 708
- EP-A- 1 641 052
- EP-A2- 0 585 186
- WO-A-2004/102685
- JP-A- 2001 033 666
- JP-A- 2003 035 883
- JP-A- 2004 172 579
- US-A- 4 907 044
- PATENT ABSTRACTS OF JAPAN Bd. 012, Nr. 318 (E-650), 29. August 1988 (1988-08-29) & JP 63 081995 A (HITACHI LTD), 12. April 1988 (1988-04-12)

## Beschreibung

Die Erfindung betrifft eine Beleuchtungsvorrichtung mit einem zur Strahlungserzeugung vorgesehenen Halbleiterchip. Derartige Beleuchtungsvorrichtungen werden oftmals zur Beleuchtung ebener Flächen eingesetzt. Herkömmliche Halbleiterchips weisen häufig eine vergleichsweise engwinklige Abstrahlcharakteristik auf, so dass ein Großteil der vom Halbleiterchip erzeugten Strahlung in einen vergleichsweise engen Raumwinkelbereich abgestrahlt wird. Eine großflächige Beleuchtung mit einem derartigen Halbleiterchip ist aufgrund der engwinkligen Abstrahlcharakteristik des Halbleiterchips erschwert. Zur Verbreiterung der Abstrahlcharakteristik kann ein optisches Element eingesetzt werden.

Ein derartiges optisches Element ist beispielsweise in US 4,907,044 beschrieben. Der Halbleiterchip ist jeweils mit dem optischen Element umformt. In Figur 4 der US 4,907,044 ist eine Radial-LED mit einem derartigen optischen Element gezeigt, während Figur 8 eine so genannte Overmold-LED-Bauform mit dem optischen Element zeigt. Bei beiden Bauformen wird zuerst der Halbleiterchip auf den Anschlüssen kontaktiert nachfolgend mit dem optischen Element umgeben, wobei die Overmold-Bauform im Gegensatz zur Radial-Bauform zur Oberflächenmontage geeignet ist. Aufgrund der allseitigen Umhüllung des Halbleiterchips mit dem optischen Element besteht bei diesen Bauformen bei hoher Strahlungsleistung die erhöhte Gefahr einer Schädigung des optischen Elements, etwa aufgrund der bei der Strahlungserzeugung anfallenden Verlustwärme. Die in der US 4,907,044 gezeigten Bauteile sind demnach für Hochleistungsanwendungen zur Erzeugung hoher Strahlungsleistungen mit einer dementsprechend hohen Abwärme nur bedingt geeignet.

EP 1376708 offenbart eine Beleuchtungsvorrichtung umfassend einen Gehäusekörper, einen strahlungsemittierenden Halbleiterchip, und ein separates optisches Element das ein Befestigungselement aufweist. US 4,907,044 offenbart eine Leuchtdiode mit einer Strahlungsaustrittsfläche die einen konkav gekrümmten Teilbereich und einem konvex gekrümmten Teilbereich aufweist. EP 0585186 und JP 2001-033666 offenbaren eine Beleuchtungsvorrichtung umfassend einen Gehäusekörper, einen strahlungsemittierenden Halbleiterchip, und ein separates optisches Element das ein Befestigungselement und ein Führungselement aufweist.

Aufgabe der vorliegenden Erfindung ist es, eine verbesserte Beleuchtungsvorrichtung anzugeben.

Diese Aufgabe wird erfindungsgemäß durch eine Beleuchtungsvorrichtung mit den Merkmalen des Patentanspruchs 1 gelöst. Vorteilhafte Ausgestaltungen und Weiterbildungen der Erfindung sind Gegenstand der abhängigen Patentansprüche.

Mit Vorteil kann das optoelektronische Bauteil im Wesentlichen unabhängig vom separaten optischen Element ausgebildet sein. Das optoelektronische Bauteil kann in der Folge vereinfacht auf Hochleistungsanwendungen zur Erzeugung einer hohen Strahlungsleistung hin optimiert werden, ohne die Gefahr einer Schädigung des optischen Elements, aufgrund der hohen Abwärme zu erhöhen.

In einer bevorzugten Ausgestaltung ist der Halbleiterchip als Dünnfilm-Halbleiterchip ausgeführt. Als Dünnfilm-Halbleiterchip wird im Rahmen der Anmeldung ein Halbleiterchip angesehen, während dessen Herstellung das Aufwachssubstrat, auf den eine Halbleiterschichtenfolge, die ein Halbleiterkörper des Dünnfilm-Halbleiterchips umfasst, beispielsweise epitaktisch, aufgewachsen wurde, gedünnt oder, insbesondere vollständig, abgelöst ist. Der Halbleiterkörper ist bevorzugt auf einem Träger angeordnet, der den Halbleiterkörper mechanisch stabilisiert und besonders bevorzugt vom Aufwachssubstrat für die Halbleiterschichtenfolge des Halbleiterkörpers verschieden ist.

Der Träger des Dünnfilm-Halbleiterchips unterliegt mit Vorteil nicht den vergleichsweise hohen Anforderungen, die ein Aufwachssubstrat, etwa hinsichtlich der Kristallstruktur, erfüllen muss. Die Freiheitsgrade bei der Auswahl des Trägers sind gegenüber den Freiheitsgraden bei der Auswahl des Aufwachssubstrats vorteilhaft erhöht. Beispielsweise kann der Träger hinsichtlich thermischer Eigenschaften, wie einen an den Halbleiterkörper angepassten thermischen Ausdehnungskoeffizienten oder einer hohen Wärmeleitfähigkeit, vergleichsweise frei gewählt werden. Eine hohe Wärmeleitfähigkeit ist bei Hochleistungsanwendungen, bei denen im Betrieb des Halbleiterchips im Halbleiterchip eine maßgebliche Wärmemenge erzeugt wird, von besonderer Bedeutung. Wird die im Halbleiterchip erzeugte Wärmemenge nicht ausreichend vom Halbleiterchip abgeführt, so ist die Gefahr einer Schädigung des Halbleiterchips erhöht. Durch den Einsatz eines vom Aufwachssubstrat verschiedenen Trägers hoher Wärmeleitfähigkeit kann diese Gefahr mit Vorteil verringert werden.

In einer weiteren Ausführungsform umfasst eine erfindungsgemäße Beleuchtungsvorrichtung einen zur Strahlungserzeugung vorgesehenen Halbleiterchip und ein optisches Element, das eine optische Achse aufweist, wobei der Halbleiterchip als Dünnfilm-Halbleiterchip ausgeführt ist, das optische Element eine Strahlungsaustrittsfläche aufweist und die Strahlungsaustrittsfläche einen konkav gekrümmten Teilbereich und einen den konkav gekrümmten Teilbereich in einem Abstand zur optischen Achse zumindest teilweise umgebenden, konvex gekrümmten Teilbereich aufweist, wobei die optische Achse durch den konkav gekrümmten Teilbereich verläuft.

Eine derartige Formgebung der Strahlungsaustrittsfläche des optischen Elements erleichtert die Veränderung der Abstrahlcharakteristik der Beleuchtungsvorrichtung, so dass die unter einem Winkel zur optischen Achse aus der Beleuchtungsvorrichtung ausgekoppelte Strahlungsleistung gegenüber der Abstrahlcharakteristik des Bauteils ohne optisches Element erhöht ist. Hierzu trägt insbesondere der konvex gekrümmte Teilbereich bei, der den unter großen Winkeln zur optischen Achse aus der Beleuchtungsvorrichtung ausgekoppelten Strahlungsanteil erhöht. Die Beleuchtungsvorrichtung mit einem derartigen optischen Element ist demnach zur homogenen Ausleuchtung einer vergleichsweise großen, insbesondere ebenen, Fläche auch in seitlich zur optischen Achse versetzten Flächenbereiche besonders geeignet. Bevorzugt ist die Beleuchtungsvorrichtung zur Hinterleuchtung einer Anzeigevorrichtung, etwa eines LCD (liquid crystal display), vorgesehen.

Erfindungsgemäß umfasst die Beleuchtungsvorrichtung ein optoelektronisches Bauteil, das einen Gehäusekörper und den Halbleiterchip aufweist, wobei das optische Element als separates optisches Element ausgeführt ist und das optische Element zur Befestigung am optoelektronischen Bauteil vorgesehen ist.
In einer weiteren bevorzugten Ausgestaltung verläuft die optische Achse, insbesondere des am optoelektronischen Bauteil befestigten optischen Elements, durch den Halbleiterchip. Der Halbleiterchip kann insbesondere bezüglich der optischen Achse zentriert angeordnet sein. Eine derartige Anordnung des Halbleiterchips erleichtert eine homogene Strahlformung der vom Halbleiterchip erzeugten Strahlung mittels des optischen Elements.
In einer weiteren bevorzugten Ausgestaltung ist das optische Element rotationssymmetrisch zur optischen Achse ausgeführt. Hierdurch wird mit Vorteil eine azimutal zur optischen Achse homogene und gleichförmige Abstrahlcharakteristik der Beleuchtungsvorrichtung erzielt.
In einer weiteren bevorzugten Ausgestaltung weist der konvex gekrümmte Teilbereich eine Krümmung auf, die kleiner ist als eine Krümmung des konkav gekrümmten Teilbereichs. Die homogene Ausleuchtung von mittels der Beleuchtungsvorrichtung zu beleuchtenden Flächenbereichen in einem vergleichsweise großen Abstand zur optischen Achse wird erleichtert.

Weiterhin kann der Flächeninhalt des konvex gekrümmten Teilbereichs der Strahlungsaustrittsfläche größer sein als der des konkav gekrümmten Teilbereichs. Im Bereich des konkav gekrümmten Teilbereichs aus dem optischen Element austretende Strahlung beleuchtet einen die optische Achse überquerenden Bereich der zu beleuchtenden Fläche homogen, während die aus dem konvex gekrümmten Teilbereich austretende Strahlung zur homogenen Beleuchtung von der optischen Achse beabstandeter Bereiche ausgeführt ist. Da von der optischen Achse beabstandete Flächenbereiche häufig größer sind als der die optische Achse umgebende Bereich, wird durch einen verglichen mit dem Flächeninhalt des konkav gekrümmten Teilbereichs vergrößerten Flächeninhalt des konvex gekrümmten Teilbereichs die homogene Beleuchtung der von der optischen Achse beabstandeten Flächenbereiche erleichtert. Ein Übergangsbereich zwischen dem konvex gekrümmten und dem konkav gekrümmten Teilbereich ist bevorzugt derart ausgeführt, dass der konvex gekrümmte Teilbereich und der konkav gekrümmte Teilbereich im Übergangsbereich, insbesondere ausschließlich, gemeinsame Tangenten aufweisen. Inhomogenitäten in der örtlichen Strahlungsleistungs- oder Intensitätsverteilung auf der zu beleuchtenden Fläche können so verringert oder vermieden werden. Die Strahlungsaustrittsfläche des optischen Elements kann kantenfrei und/oder insgesamt als differenzierbare Fläche ausgeführt sein.

Weiterhin kann bei der Erfindung das optische Element derart ausgebildet sein, dass zwei, insbesondere beliebige, seitens der Strahlungsaustrittsfläche aus dem optischen Element austretende Strahlen schnittfrei verlaufen, d.h. dass sich diese Strahlen nicht schneiden oder überkreuzen. Das Ausbilden von Bereichen auf der beleuchteten Fläche, die mit einer gegenüber benachbarten Bereichen mit einer erhöhten Strahlungsleistung beleuchtet werden, kann so vermieden werden. Insbesondere kann die örtlich Verteilung der Strahlungsleistung auf der zu beleuchtenden Fläche unabhängig vom Abstand der Fläche zur Beleuchtungsvorrichtung sein.

Ferner kann das optische Element derart ausgeführt werden, dass die Strahlformung durch das beziehungsweise die Strahlführung in dem optischen Element totalreflexionsfrei erfolgt. Die Fertigungstoleranzen für das optische Element sind so erhöht.

In einer weiteren bevorzugten Ausgestaltung ist der konvex gekrümmte Teilbereich gemäß einer Konvexlinse und der konkav gekrümmte Teilbereich gemäß einer Konkavlinse ausgeführt.

In einer weiteren bevorzugten Ausgestaltung weist der konvex gekrümmte Teilbereich einen ersten Bereich und einen zweiten Bereich auf, wobei die Krümmung des ersten Bereichs kleiner ist als die Krümmung des zweiten Bereichs. Bevorzugt ist der zweite Bereich weiter von der optischen Achse beziehungsweise dem konkav gekrümmten Teilbereich entfernt als der erste Bereich. Hierdurch kann mit Vorteil der unter einem vergleichsweise großen Winkel zur optischen Achse über den stärker gekrümmten zweiten Bereich aus dem optischen Element austretende Strahlungsanteil bzw. die Strahlungsleistung erhöht werden.

In einer weiteren bevorzugten Ausgestaltung nimmt die Krümmung des konvex gekrümmten Teilbereichs, insbesondere die Krümmung des zweiten Bereichs, mit wachsendem Abstand vom konkav gekrümmten Teilbereich zu. Die Krümmung kann insbesondere kontinuierlich zunehmen.

Durch eine Zunahme der Krümmung des konvex gekrümmten Teilbereichs mit wachsendem Abstand vom konkav gekrümmten Teilbereich kann der Winkel zur optischen Achse, unter dem Strahlung aus dem konvex gekrümmten Teilbereich ausgekoppelt wird, erhöht werden. Eine homogene Beleuchtung von Teilflächen der zu beleuchtenden Fläche, die einen vergleichsweise großen Abstand zur optischen Achse aufweisen, wird so erleichtert.

In einer weiteren bevorzugten Ausgestaltung ist der Gehäusekörper vorgefertigt und der Halbleiterchip ist nachträglich, nach der Vorfertigung des Gehäusekörpers am oder im Gehäusekörper angeordnet. Der Gehäusekörper ist insbesondere vor dem Anordnen des Halbleiterchips im Gehäusekörper vorgefertigt. Gegenüber einer Umformung des Halbleiterchips mit einem strahlungsdurchlässigen optischen Element, wie etwa bei den eingangs erwähnten Radial-LEDs oder Overmold-Bauformen, ist die Gefahr einer Schädigung des Halbleiterchips oder der Kontaktierung des Halbleiterchips, wie eines empfindlichen Bonddrahtes, bei der Vorfertigung des Gehäusekörpers vorteilhaft verringert.

In einer weiteren bevorzugten Ausgestaltung weist das optoelektronische Bauteil einen, insbesondere mit dem Gehäusekörper, umformten Leiterrahmen auf. Der Leiterrahmen kann beispielsweise mittels Spritzguss, Spritzpressguss oder Pressguss mit dem Gehäusekörper umformt werden. Der Gehäusekörper kann einen Kunststoff enthalten. Das optoelektronische Bauteil kann demnach ein vorgefertigtes Gehäuse, das den Gehäusekörper und den Leiterrahmen umfasst, aufweisen. Insbesondere kann das Gehäuse als sogenannte Premolded-Gehäusebauform ausgeführt sein. Bei einer derartigen Bauform wird der Halbleiterchip nach der Herstellung des Gehäuses auf den Leiterrahmen montiert.

In einer weiteren bevorzugten Ausgestaltung weist das optoelektronische Bauteil, insbesondere der Leiterrahmen, ein erstes elektrisches Anschlussteil, ein zweites elektrisches Anschlussteil und ein, insbesondere separat von den elektrischen Anschlussteilen ausgebildetes, thermisches Anschlussteil auf. Über die elektrischen Anschlussteile kann der Halbleiterchip elektrisch kontaktiert werden. Das thermische Anschlussteil ermöglicht eine gute thermische Anbindung an eine externe Wärmeleitvorrichtung, etwa eine Wärmesenke, unabhängig von der elektrischen Kontaktierung des optoelektronischen Bauteils mittels der elektrischen Anschlussteile. Die elektrischen Anschlussteile können beispielsweise leitend mit Leiterbahnen einer Leiterplatte elektrisch leitend verbunden, insbesondere verlötet, werden. Das thermische Anschlussteil kann beispielsweise mit der, vorzugsweise elektrisch von den Leiterbahnen isolierten, externen Wärmeleitvorrichtung, etwa über Verlötung, thermisch leitend verbunden werden.

In einer vorteilhaften Weiterbildung sind die elektrischen Anschlussteile und das thermische Anschlussteil seitens verschiedener Seitenflächen der Oberfläche des Gehäusekörpers jeweils zumindest teilweise Teil einer die Oberfläche des Gehäusekörpers vollständig einhüllenden Hüllfläche. Insbesondere können die elektrischen Anschlussteile und das thermische Anschlussteil seitens verschiedener Seitenflächen aus dem Gehäusekörper austreten oder an verschiedenen Seitenflächen einen Teil der Oberfläche des Gehäusekörpers bilden. Bevorzugt bilden auch die elektrischen Anschlussteile seitens jeweils verschiedener Seitenflächen der Oberfläche des Gehäusekörpers jeweils zumindest teilweise einen Teil einer die Oberfläche des Gehäusekörpers vollständig einhüllenden Hüllfläche. Eine getrennte elektrische und thermische Anschließbarkeit mittels der elektrischen Anschlussteiles bzw. des thermischen Anschlussteiles wird so erleichtert.

In einer weiteren bevorzugten Ausgestaltung ist das optoelektronische Bauteil als oberflächenmontierbares Bauteil (SMD: Surface Mountable Device) ausgeführt. Oberflächenmontierbare Bauteile zeichnen sich durch besonders einfache Handhabbarkeit, insbesondere bei der Montage auf einer Leiterplatte aus. Sie können beispielsweise mittels eines einfachen "Pick and Place"-Prozesses auf einer Leiterplatte positioniert und nachfolgend elektrisch und/oder thermisch angeschlossen werden. Weiterhin kann die Beleuchtungsvorrichtung mit dem am optoelektronischen Bauteil montierten optischen Element oberflächenmontierbar ausgeführt sein. Bei der Montage der Vorrichtung wird die Gefahr einer Schädigung des optischen Elements, etwa aufgrund der hohen Löttemperatur, mit Vorteil nicht maßgeblich erhöht.

In einer weiteren bevorzugten Ausgestaltung ist auf dem Halbleiterkörper, insbesondere zwischen dem Halbleiterkörper und dem Träger, eine Spiegelschicht angeordnet. Im Halbleiterkörper erzeugte Strahlung kann von der Spiegelschicht reflektiert werden, wodurch die auf der der Spiegelschicht gegenüberliegenden Seite aus dem Halbleiterkörper austretende Strahlungsleistung mit Vorteil erhöht werden kann. Weiterhin beugt die Spiegelschicht einer Absorption von Strahlung in auf der dem Halbleiterkörper gegenüberliegenden Seite der Spiegelschicht angeordneten Strukturen, wie etwa einem absorbierenden Träger, vor. Die Freiheitsgrade bei der Auswahl des Trägers werden so weitergehend erhöht.

Bevorzugt enthält die Spiegelschicht ein Metall beziehungsweise ist die Spiegelschicht im Wesentlichen metallisch ausgeführt. Beispielsweise enthält die Spiegelschicht Au, Al, Ag, Pt, Ti oder eine Legierung mit mindestens einem dieser Materialien. Au beispielsweise zeichnet sich durch eine hohe Reflektivität im roten Spektralbereich aus, während Ag oder Al auch im blauen oder ultravioletten Spektralbereich eine hohe Reflektivität zeigt.

Erfindunsgemäß weist das optische Element zumindest ein Befestigungselement auf, das zur Befestigung des optischen Elements am optoelektronischen Bauteil vorgesehen ist. Das Befestigungselement kann an ein vorgefertigtes optisches Element angebracht, etwa angeklebt werden. Weiterhin kann das Befestigungselement bei der Fertigung des optischen Elements gemeinsam mit dem optischen Element ausgebildet werden. Im letzteren Fall können das optische Element und das Befestigungselement einstückig ausgeführt sein. Das optische Element kann beispielsweise gegossen werden. Hierzu eignet sich beispielsweise besonders ein Spritzguss-, Spritzpressguss- oder Pressgussverfahren. Hierzu sei angemerkt, dass sich die weiter oben erwähnte vorzugsweise zur optischen Achse rotationssymmetrische Ausgestaltung des optischen Elements im Wesentlichen auf die optischen Funktionsflächen, d.h. die zur Strahlformung bzw. Strahlführung vorgesehenen Elemente des optischen Elements bezieht. Elemente, die hauptsächlich nicht der Strahlformung dienen, wie das Befestigungselement, müssen nicht notwendigerweise rotationssymmetrisch zur optischen Achse ausgeführt sein.

Mit Vorzug ist das optische Element als auf das optoelektronische Bauteil aufsteckbar ausgebildet. Ein stiftartiges Befestigungselement ist hierfür besonders geeignet.

Bevorzugt enthält das optische Element ein Reaktionsharz, etwa ein Epoxid- oder ein Acrylharz, ein Silikonharz oder ein Silikon. Das optische Element kann weiterhin ein Thermoplastmaterial enthalten. Ferner ist das optische Element bevorzugt als starrer Körper ausgeführt, der insbesondere nur unter zusätzlichen Maßnahmen, wie etwa Erhitzen oder erheblichem Kraftaufwand, plastisch verformbar ist.

In einer weiteren bevorzugten Ausgestaltung ist das Befestigungselement seitens einer Strahlungseintrittsfläche des optischen Elements angeordnet.

In einer weiteren bevorzugten Ausgestaltung weist das optoelektronische Bauteil, insbesondere der Gehäusekörper, zumindest eine Befestigungsvorrichtung auf. Eine Befestigung des optischen Elements am optoelektronischen Bauteil kann über Zusammenwirken des Befestigungselements mit der Befestigungsvorrichtung erfolgen. Die Befestigungsvorrichtung ist hierzu zweckmäßigerweise als Gegenstück zum Befestigungselement ausgebildet. Bevorzugt greift das Befestigungselement zur Befestigung des optischen Elements am optoelektronischen Bauteil in die Befestigungsvorrichtung ein.

In einer weiteren bevorzugten Ausgestaltung der Erfindung ist das optische Element zur Befestigung mittels Presspassung, Heißpresspassung, Verstemmen, Heißverstemmen, thermischem Nieten oder Kleben am optoelektronischen Bauteil vorgesehen.

Bei einer Presspassung wird das optische Element mittels des vom Befestigungselement des optischen Elements und der Befestigungsvorrichtung des optoelektronischen Bauteils aufeinander ausgeübten Drucks am Bauteil befestigt. Bevorzugt wirkt dieser Druck im wesentlichen entlang der Oberflächennormalen des Befestigungselements beziehungsweise der Befestigungsvorrichtung.

Bei der Heißpresspassung wird das Befestigungselement derart erwärmt, dass es zwar nicht fließfähig, insbesondere ohne zusätzliche Krafteinwirkung formstabil, aber dennoch plastisch formbar ist. Das erwärmte Befestigungselement formt sich unter Krafteinwirkung an die Befestigungsvorrichtung an. Nach dem Abkühlen des Befestigungselements ist das optische Element mechanisch stabil am optoelektronischen Bauteil befestigt.

Beim Verstemmen erfährt das Befestigungselement und/oder die Befestigungsvorrichtung, gegebenenfalls zusätzlich zu einem presspassenden Druck, eine mechanisch erzeugte Deformation. Hierzu wird das Befestigungselement und/oder die Befestigungsvorrichtung beispielsweise mit einem Deformationswerkzeug, etwa einer Nadel, derart deformiert, dass das optische Element mechanisch stabil am optoelektronischen Bauteil befestigt ist. Die Deformation kann insbesondere punktuell oder bereichsweise erfolgen. Beim Heißverstemmen ist das Deformationswerkzeug zusätzlich erwärmt, so dass das Befestigungselement im Kontaktbereich mit dem Werkzeug plastisch formbar und/oder fließfähig wird. Der Kraftaufwand kann beim Heißverstemmen gegenüber dem Verstemmen verringert sein.
Beim Kleben erfolgt die Befestigung mittels einer Klebeverbindung, die, etwa über ein Haftvermittlungsmaterial, zwischen dem Befestigungselement und der Befestigungsvorrichtung ausgebildet ist.
Beim thermischen Nieten wird das Befestigungselement, vorzugsweise in einem Teilbereich, derart erwärmt, dass es fließfähig wird und an das optoelektronische Bauteil, insbesondere den Gehäusekörper und/oder das Befestigungselement des Gehäusekörpers, anfließt sowie beim Abkühlen aushärtet, wobei eine mechanisch stabile Befestigung ausgebildet wird.

Erfindungsgemäß weist das optische Element zumindest ein Führungselement auf. Das Führungselement kann die Montage des optischen Elements an dem optoelektronischen Bauteil erleichtern. Vorzugsweise ist das Führungselement derart ausgeführt, dass das Befestigungselement im Falle einer leicht dejustierten Anordnung bezüglich der Befestigungsvorrichtung mittels des Führungselements zur Befestigungsvorrichtung geführt wird. Vorzugsweise kann eine derartige Führung mittels des Eigengewichts des optischen Elements oder einem mittels eines Montagewerkzeugs ausgeübten Drucks erzielt werden. Das optische Element kann insbesondere unter Führung durch das Führungselement auf das optoelektronische Bauteil "aufrutschen", wobei das Führungselement bevorzugt derart ausgebildet ist, dass das Befestigungselement in die Befestigungsvorrichtung eingreift oder in die Befestigungsvorrichtung "einrutscht". Weiterhin steht das Führungselement bei der Zuführung des Befestigungselements zur Befestigungsvorrichtung und/oder nach abgeschlossener Montage des optischen Elements bevorzugt mit dem Gehäusekörper in direktem, insbesondere mechanischem, Kontakt.

Erfindungsgemäß ist das Führungselement verglichen mit dem Befestigungselement näher an einem das optische Element seitens des Befestigungselements begrenzenden Rand angeordnet. Nach der Befestigung des optischen Elements am optoelektronischen Bauteil ist zwischen dem Führungselement und dem Befestigungselement bevorzugt zumindest ein Teil des Gehäusekörpers angeordnet.

Erfindungsgemäß ist das Führungselement außerhalb des Gehäusekörpers angeordnet und erstreckt sich in vertikaler Richtung entlang einer Seitenfläche des Gehäusekörpers. Bevorzugt steht das Führungselement mit der Seitenfläche in direktem Kontakt.
In einer weiteren bevorzugten Ausgestaltung ist das Führungselement, insbesondere auf einer dem das optische Element seitens des Befestigungselements begrenzenden Rands abgewandten Seite, angeschrägt beziehungsweise abgeschrägt ausgeführt. Durch eine derartige Schrägung kann das "Aufrutschen" des optischen Elements auf den Gehäusekörper des optoelektronischen Bauteils beziehungsweise das "Einrutschen" des Befestigungselements in die Befestigungsvorrichtung erleichtert werden.
In einer weiteren bevorzugten Ausgestaltung weist das optische Element eine Mehrzahl von Befestigungselementen und/oder Führungselementen auf. Die mechanische Stabilität der Befestigung und die Lagestabilität des montierten optischen Elements relativ zum Halbleiterchip können so aufgrund einer Mehrzahl von Befestigungselementen erhöht werden. Eine Mehrzahl von Führungselementen erleichtert die Befestigung des optischen Elements am optoelektronischen Bauteil. Weiterhin können auch die Führungselemente zur mechanischen Stabilität beziehungsweise zur Lagestabilität des optischen Elements beitragen. Insbesondere kann über die Führungselemente die Gefahr einer Schädigung des optischen Elementes, etwa aufgrund von auf die Beleuchtungsvorrichtung einwirkenden Scherkräften, verringert werden.

In einer weiteren bevorzugten Ausgestaltung ist zwischen dem am optoelektronischen Bauteil befestigten optischen Element und dem Halbleiterchip eine Zwischenschicht angeordnet.

In einer weiteren bevorzugten Ausgestaltung ist die Zwischenschicht plastisch formbar. Ein plastisch formbares Material für die Zwischenschicht kann vor der Montage des optischen Elements am optoelektronischen Bauteil auf dem optoelektronischen Bauteil bereitgestellt werden. Bei der Montage des optischen Elements am optoelektronischen Bauteil kann mittels des optischen Elements ein Druck auf das formbare Material ausgeübt werden, derart dass sich das Material beim Befestigen des optischen Elements in lateraler Richtung verteilt und die Zwischenschicht ausgebildet wird. Die Zwischenschicht kann insbesondere direkt an das optische Element, etwa seitens der Strahlungseintrittsseite angrenzen. Weiterhin ist das Material für die Zwischenschicht ohne Krafteinwirkung mit Verzug formstabil. Ein unkontrolliertes Zerfließen des Materials vor der Krafteinwirkung wird so vermieden.

In einer weiteren bevorzugten Ausgestaltung ist zwischen dem am optoelektronischen Bauteil befestigten optischen Element und dem optoelektronischen Bauteil, insbesondere zwischen der dem optischen Element zugewandten Seite des Gehäusekörpers und der Strahlungseintrittsfläche, ein Zwischenraum ausgebildet.

In einer weiteren bevorzugten Ausgestaltung enthält die Zwischenschicht ein Silikon, insbesondere ein Silikongel. Ein Silikon ist als Material für die Zwischenschicht besonders geeignet.

Bevorzugt ist der Zwischenraum als Fuge zur Aufnahme der Zwischenschicht bei einer Ausdehnung der Zwischenschicht vorgesehen. Dehnt sich die Zwischenschicht, beispielsweise aufgrund von Erwärmung, aus, so kann sich die Zwischenschicht in die Fuge ausdehnen, ohne die mechanische Belastung des optischen Elements oder des optoelektronischen Bauteils wesentlich zu erhöhen. Beim Abkühlen kann sich das optische Element aus der Fuge zurückziehen. Bevorzugt ist der Zwischenraum zwischen dem optischen Element und dem Bereich des Gehäusekörpers, der den geringsten Abstand zum optischen Element aufweist, ausgebildet.

Insbesondere kann die Strahlungseintrittsfläche vollflächig vom Gehäusekörper beabstandet sein. Dies kann durch geeignete Ausbildung des Befestigungselements erreicht werden.

In einer weiteren bevorzugten Ausgestaltung ist der Halbleiterchip in eine, insbesondere für die vom Halbleiterchip erzeugte Strahlung durchlässige, Umhüllung eingebettet. Die Umhüllung kann beispielsweise Reaktionsharz, wie ein Acryl- oder Epoxidharz, ein Silikonharz oder ein Silikon enthalten. Vorzugsweise ist die Umhüllung, insbesondere verglichen mit der Zwischenschicht starr ausgebildet, um die Gefahr einer Schädigung des Chips oder der Chipkontaktierung, die beispielsweise mittels eines Bonddrahtes, der vorzugsweise ebenfalls in die Umhüllung eingebettet ist, erfolgen kann, nicht zu erhöhen.

In einer weiteren bevorzugten Ausgestaltung ist die Zwischenschicht als Brechungsindexanpassungsschicht ausgebildet. Übermäßige Brechungsindexsprünge, die zu dementsprechend hohen Reflektionsverlusten von vom Halbleiterchip erzeugter Strahlung an den jeweiligen Grenzflächen führen würden, können so vermieden werden. Besonders bevorzugt vermindert die Zwischenschicht Brechungsindexsprünge, welche die vom Halbleiterchip erzeugte Strahlung zwischen dem Austritt aus der Umhüllung und dem Eintritt in das optische Element erfährt. Besonders bevorzugt vermindert die Zwischenschicht den Brechungsindexsprung gegenüber einem mit Luft gefüllten Freiraum anstelle der Zwischenschicht. Die Zwischenschicht verbessert mit Vorteil die optische Anbindung des optischen Elements an das optoelektronische Bauteil.

Die Zwischenschicht kann weiterhin haftvermittelnd ausgeführt sein, wodurch mit Vorteil die mechanische Anbindung des optischen Elements an das optoelektronische Bauteil verbessert wird.

In einer weiteren bevorzugten Ausgestaltung grenzt die Zwischenschicht an die Umhüllung und das optische Element an. Bevorzugt überdeckt die Zwischenschicht den Bereich des optischen Elements, in dem vom Halbleiterchip erzeugte Strahlung in das optische Element einkoppelt.

Die Umhüllung ist bevorzugt, insbesondere vollständig, im Strahlungsaustrittsbereich der Umhüllung mit der Zwischenschicht bedeckt.

Weitere Merkmale, vorteilhafte Ausgestaltungen und Zweckmäßigkeiten der Erfindung ergeben sich aus der folgenden Beschreibung der Ausführungsbeispiele in Verbindung mit den Figuren.

Es zeigen:
Figur 1 eine schematische Schnittansicht eines ersten Ausführungsbeispiels einer nicht erfindungsgemäßen Beleuchtungsvorrichtung,
Figur 2 eine schematische Schnittansicht eines für eine Beleuchtungsvorrichtung besonders geeigneten Halbleiterchips,
Figur 3 ein Beispiel für eine Abstrahlcharakteristik einer erfindungsgemäßen Beleuchtungsvorrichtung,
Figur 4 in den Figuren 4A bis 4F verschiedene schematische Ansichten eines für eine erfindungsgemäße Beleuchtungsvorrichtung besonders geeigneten optischen Elements,
Figur 5 eine schematische Aufsicht auf ein weiteres für eine erfindungsgemäße Beleuchtungsvorrichtung besonders geeignetes optisches Element,
Figur 6 eine schematische Schnittansicht eines zweiten nicht erfindungsgemäßen Ausführungsbeispiels einer Beleuchtungsvorrichtung,
Figur 7 in den Figuren 7A und 7B verschiedene schematische Ansichten eines für eine Beleuchtungsvorrichtung besonders geeigneten optoelektronischen Bauteils und
Figur 8 in den Figuren 8A bis 8D verschiedene schematische Ansichten eines optoelektronischen Bauteils gemäß Figur 7 und eines Ausführungsbeispiels einer erfindungsgemäßen Beleuchtungsvorrichtung.

Gleiche, gleichartige und gleich wirkende Elemente sind in den Figuren mit gleichen Bezugszeichen versehen.

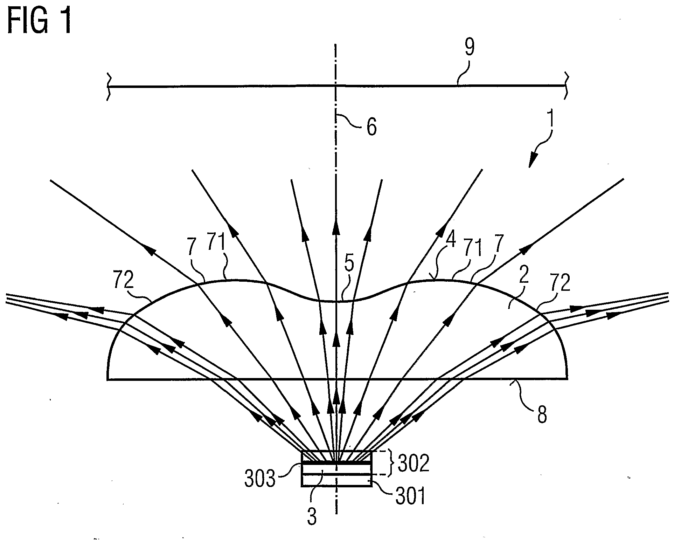

Figur 1 zeigt eine schematische Schnittansicht eines ersten Ausführungsbeispiels einer nicht erfindungsgemäßen Beleuchtungsvorrichtung.

Die Beleuchtungsvorrichtung 1 umfasst ein optisches Element 2 und einen zur Strahlungserzeugung vorgesehenen Halbleiterchip 3 .

Eine Strahlungsaustrittsfläche 4 des optischen Elements 2 weist einen konkav gekrümmten Teilbereich 5, durch den die optische Achse 6 des optischen Elements verläuft, und einen den konkav gekrümmten Teilbereich in einem Abstand zur optischen Achse umgebenden konvex gekrümmten Teilbereich 7 auf. Der konvexe und der konkave Teilbereich können insbesondere gemäß einer Konvex- oder Konkavlinse ausgeführt sein.

In einer aktiven Zone 303 des auf der optischen Achse 6 angeordneten Halbleiterchips 3 emittierte Strahlung tritt über eine Strahlungseintrittsfläche 8, die vorzugsweise eben ausgeführt ist, in das optische Element 2 ein. Die vom Halbleiterchip erzeugte Strahlung, insbesondere sichtbare Strahlung, wird in Figur 1 durch die mit Pfeilen gekennzeichneten Linien, welche einzelne Lichtstrahlen symbolisieren, verdeutlicht.

Das optische Element 2 ist zur homogenen Beleuchtung einer Fläche 9, etwa einer Diffusorfolie oder für eine Anzeigevorrichtung, wie ein LCD, ausgebildet. Die optische Achse verläuft bevorzugt durch die Fläche 9. Besonders bevorzugt verläuft die Fläche 9 im Wesentlichen senkrecht zur optischen Achse 6.

Das optische Element ist zur homogenen Beleuchtung der Fläche 9 ausgebildet. Über geeignete Ausbildung der Krümmungen des konvex und des konkav gekrümmten Teilbereichs kann die vom Halbleiterchip erzeugte Strahlung strahlungsaustrittsseitig derart verteilt werden, dass die Fläche 9 mittels der Beleuchtungsvorrichtung gleichmäßig und homogen ausgeleuchtet wird. Auf verschiedene, gleichgroße Bereiche der Fläche trifft mit Vorzug jeweils im Wesentlichen die gleiche Strahlungsleistung.

Über den konkaven Teilbereich 5 austretende Strahlung wird ähnlich wie bei einer Zerstreuungslinse gestreut. Insbesondere wird unter einem von 90° verschiedenen Winkel zur optischen Achse auf die Strahlungsaustrittsfläche auftreffende Strahlung beim Eintritt in das optische Element von der optischen Achse weg gebrochen. Die aus dem konkaven Teilbereich austretende Strahlung dient der homogenen Ausleuchtung eines die optische Achse 6 umgebenden Bereichs der Fläche 9.

Für eine azimutal um die optische Achse 6 umlaufend gleichförmige Abstrahlcharakteristik der Beleuchtungsvorrichtung ist das optische Element mit Vorzug rotationssymmetrisch zur optischen Achse 6 ausgeführt.

Vergleichsweise weit von der optischen Achse beabstandete Bereiche der Fläche 9 werden mittels über den konvex gekrümmten Teilbereich 7 unter einem von 90° verschiedenen Winkel zur optischen Achse 6 aus dem optischen Element 2 austretender Strahlung beleuchtet. Der Übergangsbereich zwischen dem konkaven und dem konvexen Teilbereich ist mit Vorzug glatt, insbesondere kantenfrei, ausgebildet ist. Insbesondere kann die Strahlungsaustrittsfläche, bevorzugt vollflächig, differenzierbar ausgeführt sein. Eine homogene Ausleuchtung der Fläche 9 wird so erleichtert.

Der konvex gekrümmte Teilbereich der Strahlungsaustrittsfläche weist bevorzugt einen größeren Flächeninhalt auf als der konkav gekrümmte Teilbereich. In der Folge tritt gegenüber dem konkav gekrümmten Teilbereich ein erhöhter Anteil an Strahlung über den konvex gekrümmten Teilbereich aus dem optischen Element aus.

Weiterhin weist der konvex gekrümmte Teilbereich bevorzugt einen ersten Bereich 71 einer ersten Krümmung und einen zweiten Bereich 72 einer zweiten Krümmung auf. Die erste Krümmung ist hierbei bevorzugt kleiner als die zweite Krümmung.

Aufgrund der im zweiten Bereich 72 größeren Krümmung weist im zweiten Bereich aus dem optischen Element 2 austretende Strahlung mit Vorteil einen größeren Winkel zur optischen Achse 6 auf als im ersten Bereich 71 oder im konkaven Teilbereich 5 aus dem optischen Element austretende Strahlung. Die homogene Ausleuchtung vergleichsweise weit von der optischen Achse entfernter Bereiche der Fläche 9 wird so erleichtert.

Bevorzugt tritt Strahlung aus dem optischen Element lediglich unter einem Winkel kleiner 90 Grad zur optischen Achse aus dem optischen Element aus. Die Beleuchtungsvorrichtung strahlt insbesondere seitlich oder quer zur optischen Achse und nach vorne, in Richtung der optischen Achse. Die Beleuchtungsvorrichtung 1 ist mit Vorzug derart ausgeführt, dass ein Großteil der Strahlungsleistung unter einem Winkel zur optischen Achse, insbesondere über den konvex gekrümmten Teilbereich, aus dem optischen Element austritt.

Die Krümmung des konvexen Teilbereichs kann mit wachsendem Abstand vom konkav gekrümmten Teilbereich, insbesondere im zweiten Bereich 72 in Richtung der Strahlungseintrittsfläche 8 zunehmen, wodurch eine vermehrte Auskopplung von Strahlung unter großen Winkeln zur optischen Achse und damit das Beleuchten vergleichsweise weit von der optischen Achse entfernten Bereichen der Fläche 9 erleichtert wird.

Die Beleuchtungsvorrichtung 1 kann derart ausgeführt sein, dass sich aus dem optischen Element austretende Strahlen nicht überschneiden, sodass die örtliche Strahlungsleistungsverteilung auf der zu beleuchtenden Fläche im wesentlichen unabhängig vom Abstand der Fläche zur Beleuchtungsvorrichtung ist.

Würde das optische Element bei der Strahlformung eine Überkreuzung von Strahlen hervorrufen, so könnte sich ein Fokalbereich ausbilden, so dass die örtliche Strahlungsleistungsverteilung auf der Fläche abhängig vom Abstand der Fläche zum optischen Element wäre. Bei einer Variation des Abstandes der Fläche 9 zum optischen Element 2 würden sich insbesondere Inhomogenitäten, etwa Ringe höherer Intensität, der örtlichen Strahlungsleistungsverteilung ausbilden. Diese Inhomogenitäten werden durch Überkreuzung von Strahlen hervorgerufen. Bei dem in Figur 1 gezeigten optischen Element ist jedoch, aufgrund der schnittfrei verlaufenden Strahlung, die örtliche Verteilung der Strahlungsleistung auf der Fläche 9 unabhängig vom Abstand der Fläche zum optischen Element 2. Weiterhin erfolgt die Strahlformung oder die Strahlführung im optischen Element mit Vorzug totalreflexionsfrei.

Bevorzugt ist das optische Element als separates optisches Element ausgebildet, das zur Befestigung an einem optoelektronischen Bauteil, das den Halbleiterchip umfasst, vorgesehen ist. Das optoelektronische Bauteil kann so unabhängig vom optischen Element für eine Hochleistungsanwendung optimiert sein und nachfolgend mit dem separaten optischen Element versehen werden. Die einzelnen Komponenten der Beleuchtungsvorrichtung können daher unabhängig voneinander auf ihre jeweilige Hauptfunktion, Strahlformung im Falle des optischen Elements beziehungsweise Strahlungserzeugung im Falle des Bauteiles, hin optimiert gefertigt werden.

Der Halbleiterchip 3 ist weiterhin bevorzugt als Dünnfilm-Halbleiterchip ausgeführt. Ein Halbleiterkörper 302 des Halbleiterchips 3, der eine Halbleiterschichtenfolge mit der aktiven Zone 303 umfasst, ist auf einem Träger 301 angeordnet, der von einem Aufwachssubstrat, auf dem der Halbleiterkörper, insbesondere die Halbleiterschichtenfolge, vorzugsweise epitaktisch, gewachsen wurde, verschieden ist. Der Träger 301 muss demnach nicht den hohen Anforderungen an ein Aufwachssubstrat genügen, sondern kann beispielsweise hinsichtlich der Wärmeableitungseigenschaften optimiert ausgeführt sein. Ein Dünnfilm-Halbleiterchip, bei dem das Aufwachssubstrat während der Herstellung abgelöst ist, ist demnach für Hochleistungsanwendungen mit vergleichsweise hoher im Halbleiterchip entstehender Verlustwärme besonders geeignet.

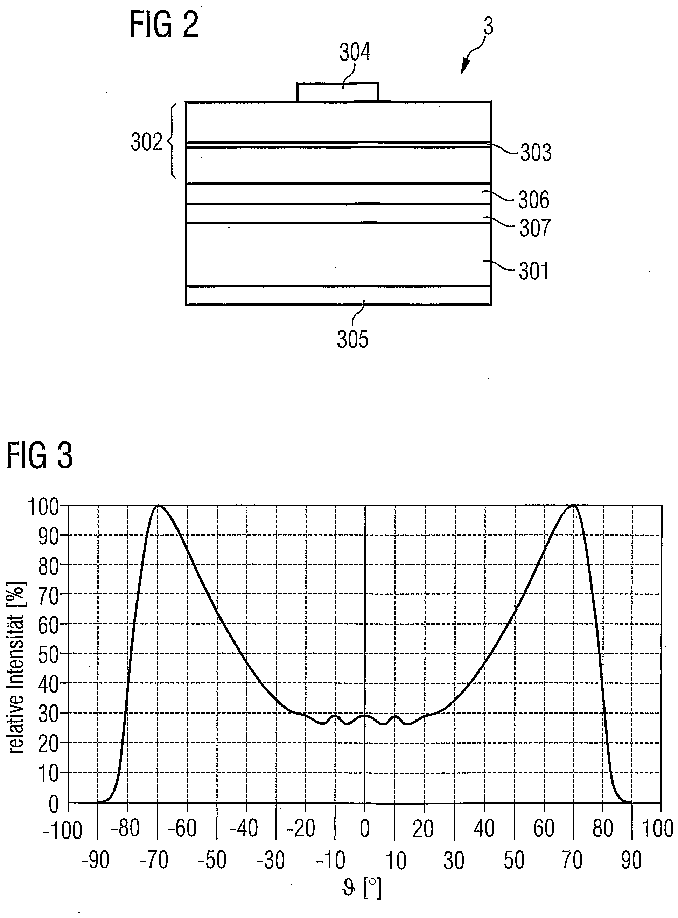

In Figur 2 ist ein Ausführungsbeispiel eines für eine Beleuchtungsvorrichtung besonders geeigneten Halbleiterchips anhand einer schematischen Schnittansicht dargestellt.

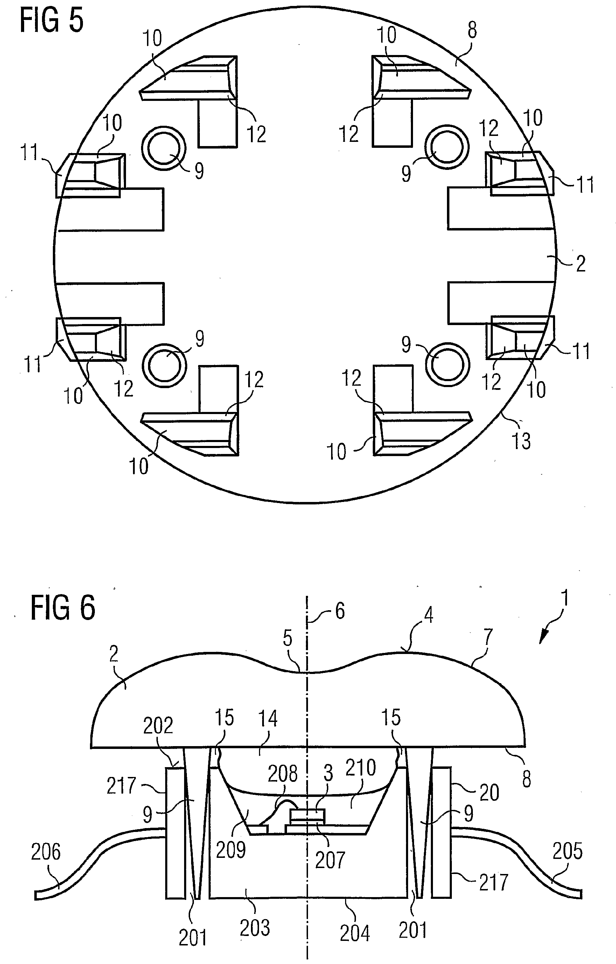

Der Halbleiterchip 3, etwa ein LED-Chip, weist eine auf einem Träger 301 angeordneten Halbleiterkörper 302 auf, der eine Halbleiterschichtenfolge mit einer zur Strahlungserzeugung vorgesehene aktive Zonen 303 umfasst. Auf der dem Träger abgewandten Seite des Halbleiterkörpers ist ein erster Kontakt 304 angeordnet, über den der Halbleiterchip 3 in Verbindung mit einem auf der dem Halbleiterkörper abgewandten Seite des Trägers angeordneten zweiten Kontakt 305 elektrisch anschließbar ist. Der erste Kontakt 304 ist insbesondere zur leitenden Verbindung mit einem Bonddraht und der zweite Kontakt 305 zur leitenden Verbindung mit einem Anschlussleiter (vgl. hierzu z.B. die im Zusammenhang mit den Figuren 6, 7 und 8 beschriebenen Bauteile) vorgesehen. Die Kontakte können beispielsweise jeweils ein Metall oder eine Legierung enthalten.

In einer bevorzugten Ausgestaltung enthält der Halbleiterkörper 302, insbesondere die aktive Zone 303, mindestens ein III-V-Halbleitermaterial, etwa ein Material aus den Materialsystemen Inₓ Ga_{y} Al_{1-x-y} P, Inₓ Ga_{y} Al_{1-x-y} N oder Inₓ Ga_{y} Al_{1-x-y} As, jeweils mit 0≤x≤1, 0≤y≤1 und x+y≤1.

III-V-Halbleitermaterialien sind zur Strahlungserzeugung im ultravioletten (Inₓ Ga_{y} Al_{1-x-y} N) über den sichtbaren (Inₓ Ga_{y} Al_{1-x-y} N, insbesondere für blaue bis grüne Strahlung, oder Inₓ Ga_{y} Al_{1-x-y} P, insbesondere für gelbe bis rote Strahlung) bis in den infraroten (Inₓ Ga_{y} Al_{1-x-y} As) Spektralbereich besonders geeignet. Mit III-V-Halbleitermaterialien, insbesondere aus den genannten Materialsystemen, zeichnen können weiterhin bei der Strahlungserzeugung vorteilhaft hohe interne Quanteneffizienzen erzielt werden.

In einer weiteren bevorzugten Ausgestaltung umfasst die aktive Zone 303 eine Heterostruktur, insbesondere eine Doppelheterostruktur. Weiterhin kann die aktive Zone eine Einfach- oder eine Mehrfach-Quantentopfstruktur umfassen. Mittels derartiger Strukturen, insbesondere einer Mehrfach-Quantentopfstruktur oder einer Doppelheterostruktur, können besonders hohe interne Quanteneffizienzen erzielt werden.

Die Bezeichnung Quantentopfstruktur umfasst im Rahmen der Anmeldung jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

In einer weiteren bevorzugten Ausgestaltung ist zwischen dem Halbleiterkörper 302 und dem Träger 301 eine Spiegelschicht 306 angeordnet. Die Spiegelschicht kann beispielsweise als metallhaltige, insbesondere im Wesentlichen metallische, Spiegelschicht ausgeführt sein. In der aktiven Zone erzeugte Strahlung kann an der Spiegelschicht reflektiert werden, wodurch eine Absorption in der der Spiegelschicht von der aktiven Zone aus gesehen nachgeordneten Strukturen, etwa dem Träger, vorgebeugt wird. Die Effizienz des Halbleiterchips 3 kann so erhöht werden. Beispielsweise enthält die Spiegelschicht Au, Al, Ag, Pt, Ti oder eine Legierung mit mindestens einem dieser Materialien. Al und Ag weisen im ultravioletten und blauen Spektralbereich, Au auch im gelben, orangen und roten bis in den infraroten Spektralbereich besonders hohe Reflektivitäten auf. Weiterhin wird durch Reflexion an der Spiegelschicht der Anteil an der der Spiegelschicht 306 gegenüberliegenden Seite des Halbleiterkörpers 302 austretenden Strahlung erhöht.

In einer weiteren bevorzugten Ausgestaltung ist zwischen dem Träger 301 und der Spiegelschicht 306 eine Verbindungsschicht 307 angeordnet, mittels derer der Halbleiterkörper seitens der Spiegelschicht auf dem Träger befestigt ist. Die Verbindungsschicht 307 kann beispielsweise als Lotschicht ausgeführt sein.

Der in Figur 2 gezeigte Halbleiterchip 3 ist als Dünnfilm-Halbleiterchip ausgeführt, was bedeutet, dass während der Herstellung des Halbleiterchips das Aufwachssubstrat, auf dem die Halbleiterschichtenfolge für den Halbleiterchip, beispielsweise mittels Epitaxie, gewachsen wurde, abgelöst wird. Der Träger 301 ist demnach insbesondere von dem Aufwachssubstrat verschieden und muss nicht den hohen Anforderungen an ein Aufwachssubstrat genügen, sondern kann hinsichtlich weiterer für den Halbleiterchip vorteilhafter Eigenschaften, etwa einer hohen thermischen Leitfähigkeit, vergleichsweise frei gewählt werden.

Bevorzugt weist der Träger eine vergleichsweise hohe Wärmeleitfähigkeit auf. Beispielsweise enthält der Träger Ge. Auch ein GaAs-Träger kann Anwendung finden.

Die aktive Zone 303 ist bevorzugt mit dem zweiten Kontakt 305 über den elektrisch leitfähigen Träger, die elektrisch leitfähige Verbindungsschicht und die elektrisch leitfähige Spiegelschicht sowie die Halbleiterschichtenfolge elektrisch leitend verbunden.

Enthält der Träger ein Halbleitermaterial, so ist der Träger mit Vorzug zur Erhöhung der Leitfähigkeit geeignet dotiert.

Zur Herstellung eines Dünnfilm-Halbleiterchips wird beispielsweise zunächst die Halbleiterschichtenfolge für den Halbleiterkörper 302 auf dem Aufwachssubstrat hergestellt. Nachfolgend wird auf die dem Aufwachssubstrat abgewandte Seite der Halbleiterschichtenfolge die Spiegelschicht, etwa mittels Aufdampfen, insbesondere Sputtern, aufgebracht. Seitens der Spiegelschicht wird der Verbund mit Halbleiterschichtenfolge und Aufwachssubstrat hierauf über die Verbindungsschicht 307 mit dem Träger 301 verbunden, woraufhin das Aufwachssubstrat, etwa mittels Ätzen oder Lasertrennen, entfernt oder abgelöst wird.

Dünnfilm-Halbleiterchips zeichnen sich, insbesondere mit einer Spiegelschicht, durch eine vorteilhaft hohe Effizienz aus. Weiterhin kann ein Dünnfilm-Halbleiterchip eine im Wesentlichen einem Lambertschen Strahler entsprechende kosinusförmige Abstrahlcharakteristik aufweisen. Mittels eines Dünnfilm-Halbleiterchip, insbesondere mit metallhaltiger Spiegelschicht, kann vereinfacht ein als Oberflächenstrahler ausgeführter Halbleiterchip realisiert werden.

Ein Dünnfilm-Halbleiterchip, etwa ein Dünnfilm-Leuchtdioden-Chip, kann sich weiterhin durch folgende charakteristische Merkmale auszeichnen:
- an einer zu einem Trägerelement, z.B. dem Träger 301, hin gewandten ersten Hauptfläche einer Halbleiterschichtenfolge, die eine aktive Zone umfasst, insbesondere einer Epitaxieschichtenfolge, ist eine Spiegelschicht aufgebracht oder, etwa als Braggspiegel in der Halbleiterschichtenfolge integriert, ausgebildet, die zumindest einen Teil der in der Halbleiterschichtenfolge erzeugten Strahlung in diese zurückreflektiert;
- die Halbleiterschichtenfolge weist eine Dicke im Bereich von 20*µ*m oder weniger, insbesondere im Bereich von 10 *µ*m auf; und
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, d.h. sie weist ein möglichst ergodisch stochastisches Streuverhalten auf.

Ein Grundprinzip eines Dünnfilm-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug in die vorliegende Anmeldung aufgenommen wird.

Es sei angemerkt, dass die Beleuchtungsvorrichtung selbstverständlich nicht nur mit einem Dünnfilm-Halbleiterchip realisiert werden kann. Auch ein anderer Halbleiterchip, wie etwa ein Halbleiterchip, bei dem das Aufwachssubstrat nicht abgelöst ist, können für eine Beleuchtungsvorrichtung geeignet sein. Aufgrund der hohen Effizienz und einer vereinfacht erzielbaren, mit Vorzug vermehrt direkt in Richtung des optischen Elements gerichteten, Oberflächenemission ist ein Dünnfilm-Halbleiterchip jedoch besonders geeignet.

In Figur 3 ist ein Beispiel für eine Abstrahlcharakteristik einer erfindungsgemäßen Beleuchtungsvorrichtung gezeigt. Aufgetragen ist die relative Intensität in Prozent in Abhängigkeit vom Winkel ϑ in ° zur optischen Achse.

Die hier gezeigte Abstrahlcharakteristik wurde für ein optisches Element 2 gemäß Figur 1, das rotationssymmetrisch zur optischen Achse ausgeführt ist, und einen Halbleiterchip 3 gemäß Figur 2 ermittelt, der im Abstand von 0,6 mm von der Strahlungseintrittsfläche 8 angeordnet war.

Die Beleuchtungsvorrichtung emittiert mit Vorzug einen Großteil der Strahlungsleistung seitlich zur optischen Achse, insbesondere unter vergleichsweise großen Winkeln. Bevorzugt weist die im die optische Achse umgebenden, konkav gekrümmten Teilbereich ausgekoppelte Strahlungsleistung ein lokales Minimum der Charakteristik auf, insbesondere im Winkelbereich zwischen 0° und 10°.

Weiterhin emittiert die Beleuchtungsvorrichtung bevorzugt mehr als 50 %, besonders bevorzugt mehr als 60% der vom Halbleiterchip erzeugten Strahlungsleistung in einen Winkelbereich zwischen 80° und 40° zur optischen Achse.

Das Maximum der Intensität liegt bei ungefähr 70°. Von dem konkaven Teilbereich 5, der dem Bereich um 0° entspricht, ausgehend wächst die Intensität mit steigendem Winkel, was dem konvex gekrümmten Teilbereich entspricht, etwa gemäß einer Potenzfunktion, insbesondere gemäß einer Parabel, und fällt nach dem Erreichen des Maximums steil ab.

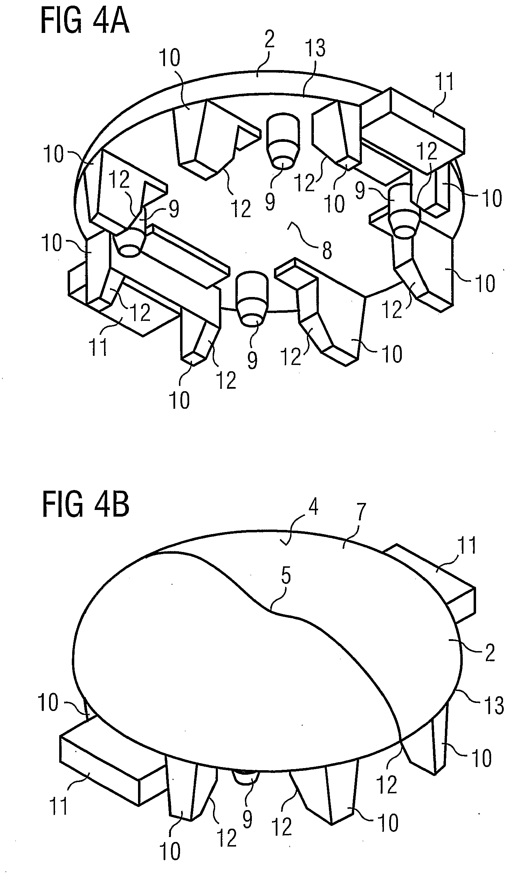

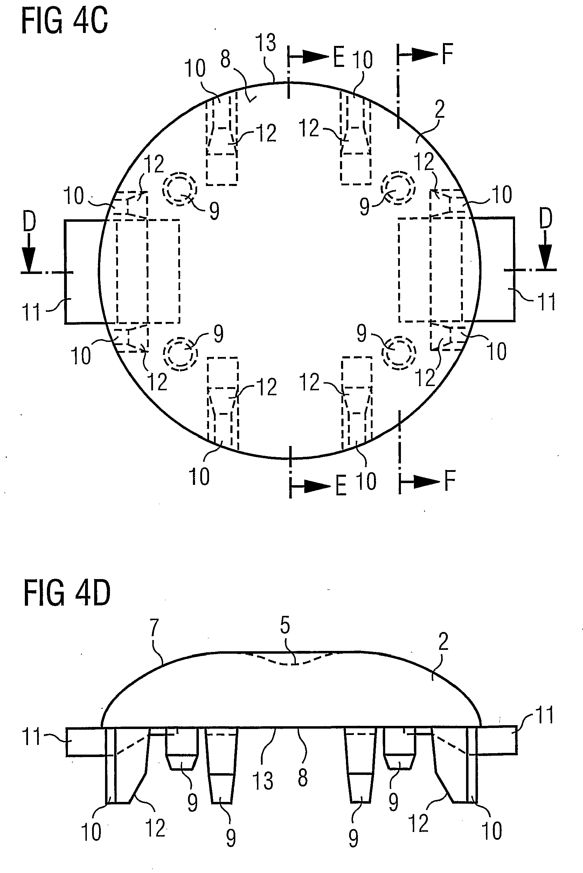

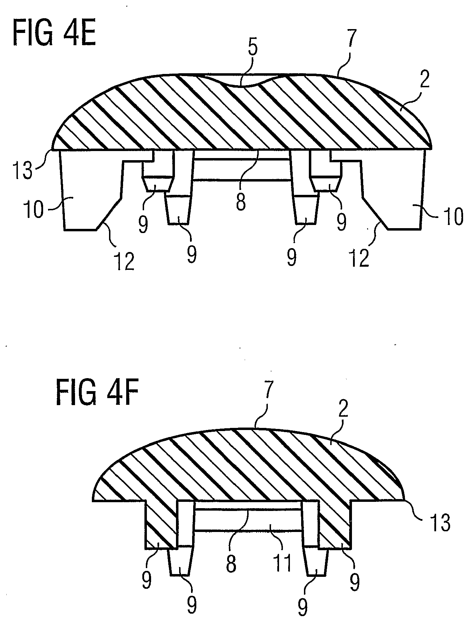

Figur 4 zeigt in den Figuren 4A bis 4F verschiedene schematische Ansichten eines für eine erfindungsgemäße Beleuchtungsvorrichtung besonders geeigneten optischen Elements 2. Hierbei zeigt Figur 4A eine Schrägansicht von unten auf die Strahlungseintrittsfläche 8 des optischen Elements, Figur 4B eine Schrägansicht von oben auf die Strahlungsaustrittsfläche 4 des optischen Elements, Figur 4C eine Aufsicht auf die Strahlungseintrittsfläche, Figur 4D eine Seitenansicht, Figur 4E eine Schnittansicht entlang der Linie E-E aus Figur 4C und Figur 4F eine Schnittansicht entlang der Linie F-F in Figur 4C.

Im wesentlichen entspricht das optische Element dem in Figur 1 gezeigten optischen Element. Im Unterschied zum optischen Element gemäß Figur 1, bei dem im wesentlichen die optischen Funktionsbereiche des optischen Elements 2 gezeigt sind, weist das optische Element 2 gemäß dem in Figur 4 gezeigten Ausführungsbeispiel eine Mehrzahl von Befestigungselementen 9 und Führungselementen 10 auf. Weiterhin weist das optische Element zumindest ein Orientierungselement 11, vorzugsweise eine Mehrzahl von Orientierungselementen, auf.

Das optische Element 2 ist insbesondere zur Befestigung an einem separaten optoelektronischen Bauteil, das einen Gehäusekörper und den Halbleiterchip der Beleuchtungsvorrichtung aufweist, ausgebildet (vgl. hierzu die Figuren 6, 7 und 8).

Das optische Element 2 ist strahlungsdurchlässig ausgeführt und enthält beispielsweise ein strahlungsdurchlässiges Silikon oder ein Silikonharz.

Das optische Element kann gegebenenfalls auch ein Reaktionsharz, etwa ein Acryl- oder Epoxidharz, enthalten und/oder silikonfrei ausgeführt sein. Gegebenenfalls kann das optische Element ein Thermoplastmaterial enthalten oder aus einem Thermoplastmaterial bestehen.

Das optische Element ist bevorzugt mittels Spritzguss, Spritzpressguss oder Pressguss hergestellt. Mittels dieser Verfahren können auch die Befestigungselemente 9, die Führungselemente 10 und/oder die Orientierungselemente 11 hergestellt sein. Insbesondere können die genannten Elemente und das optische Element einstückig ausgebildet sein. Bevorzugt ist das optische Element frei von Hinterschneidungen. Auf den Einsatz eines kostenintensiven Schiebers im Gusswerkzeug kann so verzichtet werden. Zur Erleichterung der Entformung des optischen Elements aus dem Gusswerkzeug können Befestigungselemente 9, die Führungselemente 10 und/oder die Orientierungselemente 11 angeschrägt ausgeführt sein und somit sogenannte Entformungsschrägen aufweisen.

Die Befestigungselemente 9, die Führungselemente 10 und/oder die Orientierungselemente 11 sind bevorzugt seitens der Strahlungseintrittsfläche 8 des optischen Elements angeordnet.

Die Führungselemente 10 sind zweckmäßigerweise derart ausgebildet, dass bei der Befestigung des optischen Elements 2 am optoelektronischen Bauteil die Befestigungselemente bei einer leicht dejustierten Anordnung der Befestigungselemente relativ zu den entsprechenden Befestigungsvorrichtungen des optoelektronischen Bauteils in die entsprechenden Befestigungsvorrichtungen des optoelektronischen Bauteils einrutschen oder eingeführt werden bzw. die Befestigungselemente den Befestigungsvorrichtungen zugeführt werden. Hierzu sind die Führungselemente 10 auf ihrer der Strahlungseintrittsfläche abgewandten Seite angeschrägt ausgeführt. Die Führungselemente weisen hierzu eine Abschrägung 12 auf. Die Führungselemente 10 verjüngen sich im geschrägten Bereich mit Vorzug mit wachsendem Abstand von der Strahlungseintrittsfläche 8. Bevorzugt sind die Führungselemente 10 einseitig, insbesondere auf einer einem das optische Element 2 seitens der Strahlungseintrittsfläche begrenzenden Rand 13 abgewandten Seite, angeschrägt.

Die Befestigungselemente 9 sind im Ausführungsbeispiel gemäß Figur 4 als einzelne Stifte ausgeführt. Beispielsweise sind die Befestigungselemente zur Presspassung ausgeführt und verjüngen sich, vorzugsweise durchgehend, mit wachsender Entfernung von der Strahlungseintrittsfläche 8. Ein Durchmesser der Befestigungselemente 9 kann sich demnach mit wachsendem Abstand von der Strahlungseintrittsfläche 8 verringern.

Seitens der Strahlungseintrittsfläche 8 wird das optische Element 2 durch den Rand 13 begrenzt. Die Führungselemente 10 sind verglichen mit den Befestigungselementen 9 näher am Rand 13 angeordnet. Die Befestigung des optischen Elements am optoelektronischen Bauteil wird so vorteilhaft erleichtert und die Gesamtstabilität einer Beleuchtungsvorrichtung mit dem optoelektronischen Bauteil und dem daran befestigten optischen Element wird erhöht.

Einem Befestigungselement ist bevorzugt eine Mehrzahl von Führungselementen, etwa zwei, zugeordnet, wodurch die Befestigung des optischen Elements am optoelektronischen aufgrund verbesserter Führung bei der Montage des optischen Elements mit Vorteil weitergehend erleichtert wird. Die einem Befestigungselement zugeordneten Führungselemente sind dem Befestigungselement, vorzugsweise unmittelbar, benachbart angeordnet.

Die Orientierungselemente 11 erleichtern mit Vorteil die Montage des optischen Elements am optoelektronischen Bauteil, insbesondere das orientierte Aufstecken des optischen Elements auf das Bauteil. In einem Montagewerkzeug, in das das optische Element zur Befestigung am Bauteil eingesetzt werden kann, können zu den Orientierungselement korrespondiere Orientierungsvorrichtungen vorgesehen sein, in die die Orientierungselemente, insbesondere zur mechanisch stabilen, lösbaren Befestigung des optischen Elements im Werkzeug, eingreifen. So kann eine für die Montage vorgegebene Orientierung des optischen Elements im Montagewerkzeug einer Bestückungsanlage gewährleistet werden. Bevorzugt ragen die Orientierungselemente über den Rand 13 hinaus, wodurch insbesondere Angriffspunkte für das Werkzeug gebildet werden und die Montage vereinfacht wird.

Weiterhin ist das optische Element in Aufsicht auf die Strahlungseintrittseinfläche 8 vorzugsweise im wesentlichen kreisförmig ausgebildet. Ferner ist das optische Element in Aufsicht auf die Strahlungseintrittsfläche 8 vorzugsweise achsensymmetrisch zu den Symmetrieachsen E-E und/oder D-D aus Figur 4C und/oder punktsymmetrisch zu einem Mittelpunkt der Strahlungseintrittsfläche ausgebildet.

Figur 5 zeigt ein weiteres Ausführungsbeispiel eines optischen Elements 2 für eine erfindungsgemäße Beleuchtungsvorrichtung anhand einer schematischen Aufsicht auf die Strahlungseintrittsfläche 8 dieses optischen Elements.

Das in Figur 5 gezeigt optische Element 2 entspricht im wesentlichen dem in Figur 4 gezeigten. Im Unterschied zu Figur 4 ist im optischen Element gemäß Figur 5 auf separate Orientierungselemente verzichtet. Vielmehr sind die Führungselemente 10 teilweise auch als Orientierungselemente 11 ausgebildet. Mit Vorteil kann so auf das Ausbilden separater Orientierungselemente 11 verzichtet werden. Die als Orientierungselemente ausgebildeten Führungselemente 11 ragen mit Vorzug über den Rand 13 hinaus.

In Figur 6 ist eine schematische Schnittansicht eines zweiten Ausführungsbeispiels einer nicht erfindungsgemäßen Beleuchtungsvorrichtung mit einem an einem optoelektronischen Bauteil befestigten optischen Element dargestellt.

Die Beleuchtungsvorrichtung 1 weist ein optoelektronisches Bauteil 20 auf, das den Halbleiterchip 3 umfasst. Das optische Element 2, das beispielsweise gemäß einer der vorhergehenden Figuren ausgebildet ist, ist mittels der Befestigungselemente 9 am optoelektronischen Bauteil 20 befestigt.

Für die Befestigung des optischen Elements sind in dem optoelektronischen Bauteil 1 Befestigungsvorrichtungen 201 ausgebildet, in die die Befestigungselemente 9 bei der Befestigung eingreifen. Die Befestigungsvorrichtungen 201 sind vorzugsweise als Aussparungen ausgebildet, die von einer ersten Hauptfläche 202 eines Gehäusekörpers 203 des optoelektronischen Bauteils bis zu einer der ersten Hauptfläche 202 gegenüberliegenden zweiten Hauptfläche 204 des Gehäusekörpers reichen. Die Aussparungen durchdringen den Gehäusekörper insbesondere vollständig. Die Befestigungsvorrichtungen können beispielsweise schon bei der Herstellung des Gehäusekörpers in diesem vorgeformt werden. Beispielsweise ist die Befestigungsvorrichtung zylinderartig ausgeführt. Die Befestigungsvorrichtungen können gegebenenfalls auch als den Gehäusekörper nicht vollständig durchdringende Ausnehmungen ausgebildet sein.

Die Befestigungselemente 9 sind für eine Befestigung mittels Presspassung ausgeführt. Hierzu verjüngen sich die Befestigungselemente 9 bevorzugt mit wachsender Entfernung von der Strahlungseintrittsfläche 8 des optischen Elements 2. Das optische Element 2 wird auf das optoelektronische Bauteil aufgesteckt, wobei die Befestigungselemente 9 in die Befestigungsvorrichtungen 201 eingreifen. Treten die Befestigungselemente mit dem Gehäusekörper in Kontakt wird ein Druck auf das Befestigungselement ausgeübt, der sich mit weiterem Hineinpressen des optischen Elements in die Befestigungsvorrichtung derart erhöht, dass das optische Element schließlich mittels Presspassung mechanisch stabil am Gehäusekörper 203 befestigt ist.

Die Strahlungseintrittsfläche 8 des am optoelektronischen Bauteil 20 befestigten optischen Elements 2 ist bevorzugt vom optoelektronischen Bauteil, besonders bevorzugt von dem Gehäusekörper, insbesondere dessen erster Hauptfläche 202 beabstandet. Hierzu weisen die Befestigungselemente 9, zweckmäßigerweise in einem der Strahlungseintrittsfläche 8 benachbarten Bereich, eine verglichen mit der lateralen Ausdehnung der Befestigungsvorrichtungen, insbesondere parallel zur ersten Hauptfläche, größere laterale Ausdehnung auf.

Der Abstand des Halbleiterchips zum optischen Element, insbesondere zu dessen Strahlungseintrittsfläche 8, kann 1 mm oder weniger betragen. Ein Abstand von 0,6 mm hat sich als besonders vorteilhaft herausgestellt.

Es sei angemerkt, dass sich zur Befestigung des optischen Elements am optoelektronischen Bauteil nicht nur Presspassung eignet. Auch die weiter oben angeführten Methoden, Heißpressen, Verstemmen, Heissverstemmen, thermisches Nieten oder Kleben, können, gegebenenfalls unter geeigneter Modifikation der Befestigungselemente und/oder der Befestigungsvorrichtungen, angewandt werden.

Für eine thermische Vernietung beispielsweise ragt das Befestigungselement nach dem Einführen in die Befestigungsvorrichtung seitens der zweiten Hauptfläche 204 des Gehäusekörpers 203 über die zweite Hauptfläche hinaus. In dem herausragendem Teilstück des Befestigungselements 9 wird das Befestigungselement nachfolgend derart erhitzt, dass es zumindest in diesem Teilbereich fließfähig wird. Das fließfähige Teilstück formt sich ("fließt") an die Befestigungsvorrichtung und/oder den Gehäusekörper an, so dass sich nach dem Abkühlen und dem Erstarren des Befestigungselements eine mechanisch stabile Befestigung des optischen Elements 2 am optoelektronischen Bauteil 20 ausbildet. Gegebenenfalls kann auch der Gehäusekörper im an die Befestigungselemente seitens der zweiten Hauptfläche angrenzenden Bereich erhitzt werden, so dass der Gehäusekörper und das fließfähige Befestigungselement verschmelzen.

Die laterale Ausdehnung der Befestigungsvorrichtung 201 ist für thermisches Nieten seitens der zweiten Hauptfläche bevorzugt größer als die des Befestigungselements 9 und verringert sich besonders bevorzugt in Richtung der ersten Hauptfläche 202. Das nach dem Einführen des Befestigungselements in die Befestigungsvorrichtung freie, nicht vom Befestigungselement ausgefüllte Volumen der Befestigungsvorrichtung ist zur Aufnahme des vor dem Erhitzen des Befestigungselements über die zweite Hauptfläche überstehenden Materials bestimmt. Hierfür ist die Befestigungsvorrichtung vorzugsweise im Bereich angrenzend an die zweite Hauptfläche des Gehäusekörpers mit einem sich in Richtung der ersten Hauptfläche verjüngenden, etwa trapezförmigen, Querschnitt ausgebildet. Nach der Verjüngung kann sich die Befestigungsvorrichtung im Wesentlichen zylinderförmig in Richtung der ersten Hauptfläche erstrecken.

Das optische Element 2 kann weiterhin lateral über Seitenflächen 217 den Gehäusekörper hinausragen. In dem überstehenden Bereich können an der Strahlungseintrittsfläche 8, der in diesem Bereich keine optische Funktion zukommt, Führungselemente und/oder Orientierungselemente angeordnet sein (vgl. die Ausführungen in Verbindung mit dem in Figur 4 gezeigten optischen Element)

Das optoelektronische Bauteil 20 weist einen ersten elektrischen Anschlussleiter 205 und einen zweiten elektrischen Anschlussleiter 206 auf. Diese ragen bevorzugt an verschiedenen Seitenflächen des Gehäusekörpers aus diesem heraus. Die Anschlussleiter dienen der elektrischen Kontaktierung des Halbleiterchips 3. Der Halbleiterchip 3 kann mit dem ersten Anschlussleiter 205 über eine Anschlussschicht 207, etwa eine elektrisch leitende Klebstoff- oder eine Lotschicht, elektrisch leitend verbunden und/oder auf diesem befestigt sein. Mit dem zweiten Anschlussleiter 206 ist der Halbleiterchip bevorzugt über einen Bonddraht 208 leitend verbunden.

Das optoelektronische Bauteil 20, insbesondere der Gehäusekörper, kann mittels Umgießen, etwa mittels eines Spritzguss-, Spritzpressguss- oder Pressgussverfahrens, eines die beiden Anschlussleiter 205 und 206 umfassenden Leiterrahmens mit einer geeigneten Formmasse, etwa einem Kunststoffmaterial, insbesondere einem Material auf Epoxid- oder Acrylbasis, etwa einem Reaktionsharz, hergestellt werden. Nachfolgend kann der Halbleiterchip 3 mit den Anschlussleitern verbunden werden. Das optoelektronische Bauteil kann demnach ein vorgeformtes Gehäuse, insbesondere ein sogenanntes premolded-package, aufweisen.

Bevorzugt weist der Gehäusekörper 203 eine Kavität 209 auf, in der der Halbleiterchip 3 angeordnet ist. Weiterhin kann in der Kavität 209 eine Umhüllungsmasse 210 angeordnet sein, in die der Halbleiterchip 3 eingebettet ist. Diese Umhüllung schützt den Halbleiterchip 3 und den Bonddraht 208 mit Vorteil vor schädlichen äußeren Einflüssen. Beispielsweise enthält die Umhüllung ein Reaktionsharz, etwa ein Acryl- oder Epoxidharz, ein Silikonharz oder ein Silikon. Die Umhüllung ist zur Erhöhung des Schutzes vorzugsweise starr.

Das optoelektronische Bauteil kann ferner zur Erzeugung mischfarbigen, insbesondere weißen Lichts, ausgebildet sein. Hierzu regt ein Teil der vom Halbleiterchip erzeugten Strahlung beispielsweise ein in der Umhüllungsmasse 210 angeordnetes Lumineszenzkonversionsmaterial, etwa einen Leuchtstoff, insbesondere in Partikelform, zur Emission längerwellige Strahlung an. Aus der Mischung der vom Halbleiterchip erzeugten und der vom Lumineszenzkonversionsmaterial reemittierten Strahlung kann in der Folge mischfarbiges, insbesondere weißes, Licht entstehen. Zur Weißlichterzeugung sind eine vom Halbleiterchip erzeugte Primärstrahlung im blauen Spektralbereich und eine vom Lumineszenzkonversionsmaterial reemittierte Strahlung im gelben Spektralbereich besonders geeignet.

Der Gehäusekörper 203 ist bevorzugt aus einem gut reflektierenden Material, etwa weißem Kunststoff, gefertigt. Die Wände der Kavität können zur weiteren Steigerung der Reflexion einer vom Halbleiterchip erzeugten Strahlung an der Wand der Kavität mit einem reflexionssteigernden Material, etwa einem Metall, beschichtet sein. Über Reflexion an der Wand der Kavität kann der Anteil der dem optischen Element 2 zur Strahlformung zugeführten Strahlung verglichen mit einem Gehäusekörper ohne Kavität 209 mit Vorteil erhöht werden.

Das optoelektronische Bauteil ist weiterhin bevorzugt oberflächenmontierbar (SMD: Surface Mountable Device) ausgebildet. Bei der Oberflächenmontage werden beispielsweise die Anschlussleiter 205 und 206 seitens von Lötflächen 211 und 212 der Anschlussleiter auf Leiterbahnen einer Leiterplatte (nicht dargestellt) gelötet.

Wird das optische Element 2 vor der Montage des optoelektronischen Bauteils an diesem befestigt, so ist die gesamte Beleuchtungsvorrichtung 1 mit dem optoelektronischen Bauteil 20 und dem daran befestigten optischen Element 2 oberflächenmontierbar ausgeführt.

Zwischen dem optischen Element 2 und dem Halbleiterchip 3 ist eine Zwischenschicht 14 angeordnet. Die Zwischenschicht kann an die Umhüllung 210 und strahlungseintrittseitig an das optische Element angrenzen. Die Zwischenschicht 14 kann weiterhin plastisch formbar ausgeführt sein.

Mit Vorzug ist das Material der Zwischenschicht haftvermittelnd ausgeführt, so dass die mechanische Anbindung des optischen Elements an das optoelektronische Bauteil erhöht wird.

Ferner ist die Zwischenschicht bevorzugt als Brechungsindexanpassungsschicht ausgeführt, die die Brechungsindexsprünge, welche vom Halbleiterchip 3 erzeugte Strahlung vor der Einkopplung in das optische Element erfährt, gegenüber einer fehlenden Zwischenschicht vermindert. Beispielsweise können das optische Element die Zwischenschicht und die Umhüllungsmasse derart aufeinander abgestimmt sein, dass sich die Brechungsindizes aneinandergrenzender Materialien, wie der Brechungsindex der Umhüllung zu dem der Zwischenschicht oder derjenige der Zwischenschicht zu dem des optischen Elements, zueinander wie 1,4:1,6 oder weniger, etwa 1,4:1,48, verhalten. Reflexionsverluste an Grenzflächen werden so vermindert.

Vorzugsweise enthalten die Umhüllung, die Zwischenschicht und das optische Element ein Silikon. Eine Brechungsindexanpassung kann so vereinfacht erfolgen.

Die Umhüllung und das optische Element sind verglichen mit der Zwischenschicht vorzugsweise starr, dass heißt nur unter erheblich höherem Kraftaufwand plastisch verformbar ausgeführt.

Eine Zwischenschicht, die ein Silikongel, etwa SilGel 612 der Firma Wacker Chemie, insbesondere mit einem Mischverhältnis der beiden Komponenten von ungefähr 1:1 (vergleiche hierzu das entsprechende Datenblatt), enthält, ist besonders geeignet. Ein Silikongel, insbesondere SilGel 612, kann zugleich haftvermittelnde Wirkung besitzen, plastisch formbar sein und Brechungsindexsprünge mindern. Dies gilt insbesondere, falls die Umhüllung und/oder das optische Element ein Silikon enthalten.

Die Zwischenschicht bedeckt die Umhüllung 210 und den optisch zur Strahlungseinkopplung genutzten Bereich der Strahlungseintrittsfläche 8 vorzugsweise vollständig, so dass Reflexionsverluste an Grenzflächen vorteilhaft gering gehalten werden.

Bei einer Erwärmung kann sich die Zwischenschicht in einen zwischen dem optischen Element und der ersten Hauptfläche 202 des Gehäusekörpers 203 ausgebildete Zwischenraum 15 ausdehnen, wodurch die mechanische Belastung der Beleuchtungsvorrichtung 1, insbesondere der Umhüllung 210 und des optischen Elements, bei Temperaturschwankungen vorteilhaft gering gehalten wird.

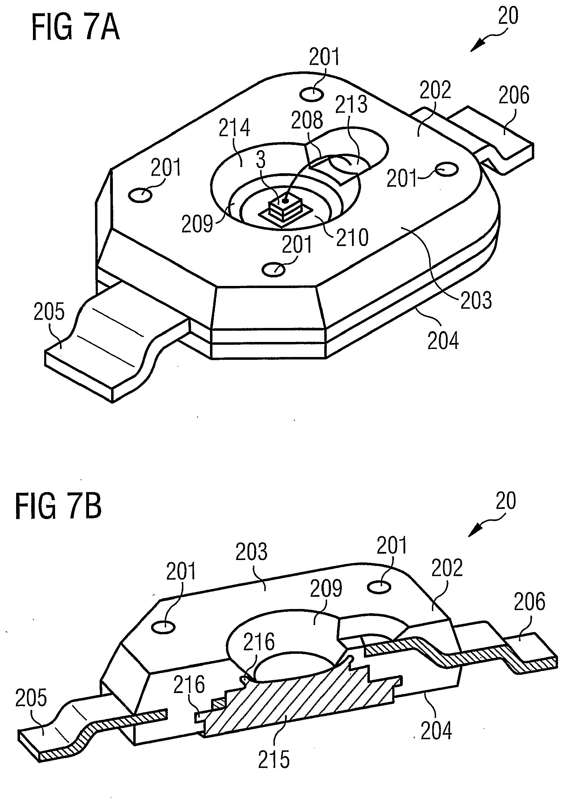

In Figur 7 ist ein für eine Beleuchtungsvorrichtung besonders geeignetes optoelektronisches Bauteil anhand einer schematischen perspektivischen Aufsicht auf das optoelektronische Bauteil in Figur 7A und einer schematischen perspektivischen Schnittansicht des Bauteils in Figur 7B dargestellt.

Ein derartiges optoelektronische Bauteil ist beispielsweise in WO 02/084749 näher beschrieben, deren Offenbarungsgehalt hiermit explizit durch Referenz in die vorliegende Anmeldung aufgenommen wird. Als optoelektronisches Bauteil ist ein Bauteil ähnlich dem mit der Typenbezeichnung LW W5SG (Hersteller: Osram Opto Semiconductors GmbH), ein damit verwandtes oder ein ähnliches Bauteil des gleichen Herstellers besonders geeignet.

Das optoelektronische Bauteil 20 umfasst einen ersten elektrischen Anschlussleiter 205 und einen zweiten elektrischen Anschlussleiter 206, die aus verschiedenen Seitenflächen des Gehäusekörpers 203 des optoelektronischen Bauteils 20 herausragen können und beispielsweise schwingenartig ausgebildet sind.

Der Gehäusekörper 203 weist eine Kavität 209 auf, in der der Halbleiterchip 3 angeordnet ist, der in eine Umhüllung 210 eingebettet ist. Der Halbleiterchip 3 ist mit dem Anschlussleiter 205 beispielsweise mittels einer Lötverbindung elektrisch leitend verbunden. Eine leitende Verbindung zum zweiten Anschlussleiter 206 wird über den Bonddraht 208 hergestellt. Der Anschluss des Bonddrahts an den zweiten Anschlussleiter 206 erfolgt mit Vorzug im Bereich einer Ausbuchtung 213 einer Wand 214 der Kavität 209.

Der Halbleiterchip 3 ist auf einem thermischen Anschlussteil 215 angeordnet, das als Chipträger fungiert. Das thermische Anschlussteil erstreckt sich in vertikaler Richtung mit Vorzug von der Kavität bis zur zweiten Hauptfläche 204 des Gehäusekörpers 203 und erleichtert einen, insbesondere gegenüber der Chipmontagefläche auf dem thermischen Anschlussteil, großflächigen, thermischen Anschluss des Halbleiterchips 3 seitens der zweiten Hauptfläche an eine externe Wärmeleitvorrichtung, etwa einen Kühlkörper, z.B. aus Cu. Die thermische Belastung des Gehäusekörpers kann so, insbesondere bei Betrieb des Bauteils als Hochleistungsbauteil mit einem Hochleistungs-Halbleiterchip, etwa einen Dünnfilm-Halbleiterchip (vgl. den im Zusammenhang mit Figur 2 beschriebenen Halbleiterchip), mit Vorteil verringert werden. Das optoelektronische Bauteil kann zur Erzeugung einer hohen Strahlungsleistung bei einer gleichzeitig aufgrund des thermischen Anschlussteils vorteilhaft verbesserten Wärmeableitung ausgebildet sein. Ein derartiges optoelektronisches Bauteil ist zur Beleuchtung von Flächen, etwa zur Hinterleuchtung einer Anzeigevorrichtung, etwa eines LCD, besonders geeignet.

Das thermische Anschlussteil ist beispielsweise in eine Lasche des ersten Anschlussleiters 205 eingeknüpft oder anderweitig mit dem ersten Anschlussleiter, insbesondere elektrisch leitend und/oder mechanisch, lateral umfangsseitig verbunden. Der zweite Anschlussleiter 206, der zur Kontaktierung mit dem Bonddraht 208 vorgesehen ist, ist vorzugsweise bezüglich der Chipmontage-Ebene des Halbleiterchips 3 auf dem thermischen Anschlussteil 215 erhöht. Die für eine Reflexion von Strahlung zur Verfügung stehende Fläche der Wand der Kavität wird so vorteilhaft groß gehalten. Weiterhin kann das thermische Anschlussteil selbst reflektierend ausgeführt sein und bildet dann mit Vorzug einen Teil des Bodens und/oder der Wand der Kavität. Das thermische Anschlussteil kann ferner seitens der zweiten Hauptfläche aus dem Gehäusekörper herausragen oder im wesentlichen eben mit dem Gehäusekörper abschließen. Beispielsweise enthält das thermische Anschlussteil ein Metall hoher Wärmeleitfähigkeit, etwa Cu oder Al, oder eine Legierung, etwa eine CuW-Legierung.

Ein Leiterrahmen mit den beiden Anschlussleitern 205 und 206 und dem thermischen Anschlussteil 215 kann bei der Herstellung eines derartigen optoelektronischen Bauteils in einem geeigneten Gussverfahren, etwa einem Spritzgussverfahren, mit dem Material des Gehäusekörpers umformt werden. Der Halbleiterchip wird nach der Herstellung des Gehäusekörpers am bzw. in dem Premolded-Gehäuse angeordnet. Das thermische Anschlussteil 215 ist vorzugsweise mit einer oder mehreren Ausbuchtungen oder Auswölbungen 216 ausgebildet, wodurch die mechanische Anbindung des thermischen Anschlussteils an den Gehäusekörper verbessert und somit die Gesamtstabilität des optoelektronischen Bauteils erhöht wird.

Seitens der ersten Hauptfläche 202 des Gehäusekörpers sind Befestigungsvorrichtungen 201 ausgebildet, die zur Befestigung des optischen Elements vorgesehen sind, wobei das optische Element beispielsweise entsprechend den weiter oben beschriebenen Ausführungsbeispielen ausgeführt sein kann. Zur Befestigung des optischen Elements am Gehäusekörper 203 können beispielsweise vier Befestigungsvorrichtungen 201 vorgesehen sein, die eine mechanisch stabile Befestigung des optischen Elements am Bauteil erleichtern. Zweckmäßigerweise sind die Befestigungsvorrichtungen 201 in den Eckbereichen der ersten Hauptfläche 202 des Gehäusekörpers 203 angeordnet.

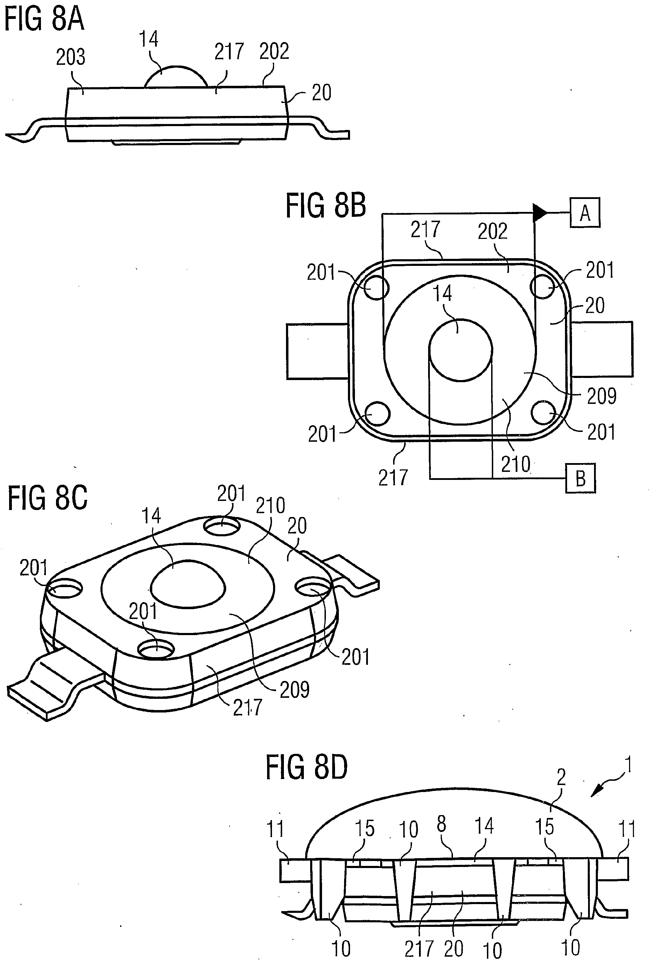

Figur 8 zeigt in den Figuren 8A bis 8D verschiedene schematische Ansichten eines optoelektronischen Bauteils und eines Ausführungsbeispiels einer erfindungsgemäßen Beleuchtungsvorrichtung. Figur 8A zeigt eine Seitenansicht des optoelektronischen Bauteils, Figur 8B eine Aufsicht auf das optoelektronische Bauteil 20, Figur 8C eine Schrägaufsicht auf das optoelektronische Bauteil von oben und Figur 8D eine Seitenansicht der Beleuchtungsvorrichtung 1 mit dem an dem optoelektronischen Bauteil befestigten optischen Element 2. Das in Figur 8 gezeigte optoelektronische Bauteil 20 ist beispielsweise gemäß dem in Zusammenhang mit Figur 7 beschriebenen Bauteil ausgeführt.

Im Unterschied hierzu gemäß Figur 8 ist auf der in der Kavität 209 angeordneten Umhüllungsmasse 210, welche vorzugsweise ein starres den Halbleiterchip und den Bonddraht 208 schützendes Material enthält, ein Material für die Zwischenschicht 14, etwa tropfen- oder halbkugelförmig, angeordnet. Der Durchmesser B des Materials für die Zwischenschicht ist mit Vorzug kleiner als der Durchmesser A der Kavität 209. Das Material der Zwischenschicht 14 ist hierbei vorzugsweise plastisch formbar ausgebildet. Beispielsweise enthält das Material ein Silikongel, etwa vom weiter oben erwähnten Typ. Das Material der Zwischenschicht kann in der flüssigen Phase auf das optoelektronische Bauteil und insbesondere die Umhüllungsmasse 210 aufgebracht, etwa aufgetropft, werden. Mit Vorzug wird es nachfolgend in eine feste, jedoch noch plastisch formbare Phase überführt. Hierzu kann das optoelektronische Bauteil geheizt, beispielsweise auf eine Temperatur von 140 Grad, werden und das aufgebrachte Material der Zwischenschicht vernetzt sich unmittelbar nach dem Aufbringen temperaturinduziert zumindest teilweise derart, dass es formstabil und formbar ist.

Das Material für die Zwischenschicht 11 überragt mit Vorzug die erste Hauptfläche 202 des Gehäusekörpers 203. Wird das optische Element 2, etwa das in Figur 4 dargestellte, von der Seite der ersten Hauptfläche 202 auf das optoelektronischen Bauteile 20 aufgesteckt und nachfolgend weitergehend und aufgedrückt, so kann die Strahlungseintrittsfläche 8 mit dem Material der Zwischenschicht 14 in Kontakt treten. Der ausgeübte Druck verteilt das Material lateral, insbesondere in einer Richtung parallel zur ersten Hauptfläche des Gehäusekörpers. Hierdurch wird die Zwischenschicht 14 ausgebildet, die mit der Umhüllung 210 und dem optischen Element in direktem mechanischen Kontakt steht. Vorzugsweise ist die Kavität 209 in lateraler Richtung vollständig von der Zwischenschicht überdeckt. Die optische Anbindung des Halbleiterchips an das optische Element wird durch eine derartig große laterale Ausdehnung der Zwischenschicht 14 verbessert.

Die Führungselemente 10 sind lateral neben den Seitenflächen 217 des Gehäusekörpers angeordnet. Bevorzugt schließen die sich die Führungselemente reibschlüssig an den Gehäusekörper an. Hierdurch wird die mechanische Stabilität des am optoelektronischen Bauteil befestigten optischen Elements und die Gesamtstabilität der Beleuchtungsvorrichtung 1 erhöht.

Die Erfindung ist nicht durch die Beschreibung anhand der Ausführungsbeispiele beschränkt.

## Patentansprüche

1. Beleuchtungsvorrichtung (1) umfassend
ein optoelektronisches Bauteil (20), das einen Gehäusekörper (203) und mindestens einen zur Strahlungserzeugung vorgesehenen Halbleiterchip (3) aufweist,
und ein separates optisches Element (2), das zur Befestigung an dem optoelektronischen Bauteil vorgesehen ist und eine optische Achse aufweist, wobei das optische Element eine Strahlungsaustrittsfläche (4) aufweist,
**dadurch gekennzeichnet, dass**
- die Strahlungsaustrittsfläche einen konkav gekrümmten Teilbereich (5) und einen den konkav gekrümmten Teilbereich in einem Abstand zur optischen Achse zumindest teilweise umgebenden, konvex gekrümmten Teilbereich (7) aufweist, wobei die optische Achse (6) durch den konkav gekrümmten Teilbereich verläuft,
- das optische Element (2) zumindest ein Befestigungselement (9) aufweist und das Befestigungselement zur Befestigung des optischen Elements am optoelektronischen Bauteil (20) vorgesehen ist,
- das optische Element (2) zumindest ein Führungselement (10) aufweist, das verglichen mit dem Befestigungselement näher an einem das optische Element (2) seitens des
Befestigungselements begrenzenden Rand (13) angeordnet ist,
- das Führungselement (10) außerhalb des Gehäusekörpers (203) angeordnet ist und sich in vertikaler Richtung an einer Seitenfläche des Gehäusekörpers (203) entlang erstreckt.

2. Beleuchtungsvorrichtung nach Anspruch 1,
**dadurch gekennzeichnet, dass**
die optische Achse (6) des am optoelektronischen Bauteil (20) befestigten optischen Elements (2) durch den Halbleiterchip (3) verläuft.

3. Beleuchtungsvorrichtung nach mindestens einem der vorhergehenden Ansprüche,
**dadurch gekennzeichnet, dass**
das optische Element (2) rotationssymmetrisch zur optischer Achse (6) ausgeführt ist.

4. Beleuchtungsvorrichtung nach mindestens einem der vorhergehenden Ansprüche,
**dadurch gekennzeichnet, dass**
der konvex gekrümmte Teilbereich (7) eine Krümmung aufweist die kleiner ist als eine Krümmung des konkav gekrümmten Teilbereichs (5).

5. Beleuchtungsvorrichtung nach mindestens einem der vorhergehenden Ansprüche,
**dadurch gekennzeichnet, dass**
der konvex gekrümmte Teilbereich (7) einen Flächeninhalt aufweist, der größer ist als der Flächeninhalt des konkav gekrümmten Teilbereichs (5).

6. Beleuchtungsvorrichtung nach mindestens einem der vorhergehenden Ansprüche,
**dadurch gekennzeichnet, dass**
der Gehäusekörper (203) vorgefertigt ist und der Halbleiterchip (3) nachträglich am Gehäusekörper angeordnet ist.

7. Beleuchtungsvorrichtung nach mindestens einem der vorhergehenden Ansprüche,
**dadurch gekennzeichnet, dass**
das optoelektronische Bauteil (20) einen, insbesondere mit dem Gehäusekörper (203), umformten Leiterrahmen aufweist.

8. Beleuchtungsvorrichtung nach mindestens einem der vorhergehenden Ansprüche,
**dadurch gekennzeichnet, dass**
das optoelektronische Bauteil (20), insbesondere der Leiterrahmen, ein erstes elektrisches Anschlussteil (205), ein zweites elektrisches Anschlussteil (206) und ein thermisches Anschlussteil (215) aufweist.

9. Beleuchtungsvorrichtung nach mindestens einem der vorhergehenden Ansprüche,
**dadurch gekennzeichnet, dass**
das optoelektronische Bauteil (20) als oberflächenmontierbares Bauteil ausgeführt ist.

10. Beleuchtungsvorrichtung nach mindestens einem der vorhergehenden Ansprüche,
**dadurch gekennzeichnet, dass**
der Halbleiterchip (3) einen auf einem Träger (301) angeordneten Halbleiterkörper (302) umfasst und der Halbleiterkörper eine Halbleiterschichtenfolge aufweist.

11. Beleuchtungsvorrichtung nach Anspruch 10,
**dadurch gekennzeichnet, dass**
der Träger (301) von einem Aufwachssubstrat für die Halbleiterschichtenfolge verschieden ist.

12. Beleuchtungsvorrichtung nach Anspruch 10 oder 11, **dadurch gekennzeichnet, dass**
auf dem Halbleiterkörper (302), insbesondere zwischen dem Halbleiterkörper und dem Träger (301), eine Spiegelschicht (306) angeordnet ist.

13. Beleuchtungsvorrichtung nach Anspruch 12,
**dadurch gekennzeichnet, dass**
die Spiegelschicht (306) ein Metall enthält.

14. Beleuchtungsvorrichtung nach mindestens einem der vorhergehenden Ansprüche,
**dadurch gekennzeichnet, dass** der konvex gekrümmte Teilbereich (7) einen ersten Bereich (71) und einen zweiten Bereich (72) aufweist, wobei die Krümmung des ersten Bereichs kleiner ist als die Krümmung des zweiten Bereichs.

15. Beleuchtungsvorrichtung nach mindestens einem der vorhergehenden Ansprüche, dass
das optoelektronische Bauteil (20), insbesondere der Gehäusekörper, zumindest eine Befestigungsvorrichtung (201) aufweist und das Befestigungselement (9) zur Befestigung des optischen Elements (2) in die Befestigungsvorrichtung des optoelektronischen Bauteils (20) eingreift.

16. Beleuchtungsvorrichtung nach mindestens einem der vorhergehenden Ansprüche,
**dadurch gekennzeichnet, dass**
das optische Element (2) zur Befestigung mittels Presspassung, Heißpresspassung, Verstemmen, Heißverstemmen, thermischem Nieten oder Kleben am optoelektronischen Bauteil (20) vorgesehen ist.

17. Beleuchtungsvorrichtung nach mindestens einem der vorhergehenden Ansprüche,
**dadurch gekennzeichnet, dass**
das Führungselement (10) auf einer dem Rand (13) abgewandten Seite angeschrägt ausgeführt ist.

18. Beleuchtungsvorrichtung nach mindestens einem der vorhergehenden Ansprüche, dass
das optische Element (2) eine Mehrzahl von Befestigungselementen (9) und Führungselementen (10) aufweist und die Anzahl der Führungselemente größer als die Anzahl der Befestigungselemente ist.

19. Beleuchtungsvorrichtung nach mindestens einem der vorhergehenden Ansprüche,
**dadurch gekennzeichnet, dass**
zwischen dem am optoelektronischen Bauteil (20) befestigten optischen Element (2) und dem Halbleiterchip (3) eine Zwischenschicht (14) angeordnet ist.

20. Beleuchtungsvorrichtung nach Anspruch 19,
**dadurch gekennzeichnet, dass**
die Zwischenschicht (14) plastisch formbar ist.

21. Beleuchtungsvorrichtung nach Anspruch 19 oder 20, **dadurch gekennzeichnet, dass**
die Zwischenschicht (14) ein Silikon, insbesondere ein Silikongel, enthält.

22. Beleuchtungsvorrichtung nach mindestens einem der vorhergehenden Ansprüche,
**dadurch gekennzeichnet, dass**
zwischen dem am optoelektronischen Bauteil (20) befestigten optischen Element (2) und dem optoelektronischen Bauteil, insbesondere zwischen der dem optischen Element (2) zugewandten Seite des Gehäusekörpers und der Strahlungseintrittsfläche, ein Zwischenraum (15) ausgebildet ist.

23. Beleuchtungsvorrichtung nach den Ansprüchen 19 und 22, **dadurch gekennzeichnet, dass**
der Zwischenraum (15) als Fuge zur Aufnahme der Zwischenschicht bei einer Ausdehnung der Zwischenschicht (14) vorgesehen ist.

24. Beleuchtungsvorrichtung nach mindestens einem der vorhergehenden Ansprüche,
**dadurch gekennzeichnet, dass**
der Halbleiterchip (3) in eine Umhüllung (210) eingebettet ist.

25. Beleuchtungsvorrichtung nach den Ansprüchen 19 und 24, **dadurch gekennzeichnet, dass**
die Zwischenschicht (14) an die Umhüllung (210) und das optische Element (2) angrenzt.

26. Beleuchtungsvorrichtung nach mindestens einem der Ansprüche 19 bis 21, 23 und 25,
**dadurch gekennzeichnet, dass**
die Zwischenschicht (14) als Brechungsindexanpassungsschicht ausgebildet ist.

27. Beleuchtungsvorrichtung nach mindestens einem der vorhergehenden Ansprüche,
**dadurch gekennzeichnet, dass**
die Beleuchtungsvorrichtung (1) zur Hinterleuchtung einer Anzeigevorrichtung, etwa eines LCD, vorgesehen ist.

## Claims

1. Illumination device (1) comprising
an optoelectronic component (20) having a housing body (203) and at least one semiconductor chip (3) provided for generating radiation, and a separate optical element (2), which is intended for fixing at the optoelectronic component, said optical element having an optical axis, wherein the optical element having a radiation exit surface (4),
**characterized in that**
- the radiation exit surface having a concavely curved partial region (5) and a convexly curved partial region (7), which at least partly surrounds the concavely curved partial region at a distance from the optical axis, the optical axis (6) running through the concavely curved partial region,
- the optical element (2) comprises at least one fixing element (9) and the fixing element is provided for fixing the optical element to the optoelectronic component (20),
- the optical element (2) comprises at least one guide element (10) arranged closer to an edge (13) defining the optical element (2) on the part of the fixing element compared to the fixing element,
- the guide element (10) is disposed outside the housing body (203) and extends in a vertical direction along a side surface of the housing body (203).

2. Illumination device according to claim 1,
**characterized in that**
the optical axis (6) of the optical element (2) fixed at the optoelectronic component (20) runs through the semiconductor chip (3).

3. Illumination device according to at least one of the previous claims,
**characterized in that**
the optical element (2) is embodied in rotationally symmetrical fashion with respect to the optical axis (6).

4. Illumination device according to at least one of the previous claims,
**characterized in that**
the convexly curved partial region (7) has a curvature which is less than a curvature of the concavely curved partial region (5) .

5. Illumination device according to at least one of the previous claims,
**characterized in that**
the convexly curved partial region (7) has a surface area which is greater than the surface area of the concavely curved partial region (5).

6. Illumination device according to at least one of the previous claims,
**characterized in that**
the housing body (203) is prefabricated and the semiconductor chip (3) is subsequently arranged at the housing body.

7. Illumination device according to at least one of the previous claims,
**characterized in that**
the optoelectronic component (20) has a leadframe which is formed around, in particular with the housing body (203).

8. Illumination device according to at least one of the previous claims,
**characterized in that**
the optoelectronic component (20), in particular the leadframe, has a first electrical connecting part (205), a second electrical connecting part (206) and a thermal connecting part (215).

9. Illumination device according to at least one of the previous claims,
**characterized in that**
the optoelectronic component (20) is embodied as a surface-mountable component.

10. Illumination device according to at least one of the previous claims,
**characterized in that**
the semiconductor chip (3) comprises a semiconductor body (302) arranged on a carrier (301) and the semiconductor body has a semiconductor layer sequence.

11. Illumination device according to claim 10,
**characterized in that**
the carrier (301) is different from a growth substrate for the semiconductor layer sequence.

12. Illumination device according to claim 10 or 11, **characterized in that**
a mirror layer (306) is arranged on the semiconductor body (302), in particular between the semiconductor body and the carrier (301) .

13. Illumination device according to claim 12,
**characterized in that**,
the mirror layer (306) contains a metal.

14. Illumination device according to at least one of the previous claims, **characterized in that**
the convexly curved partial region (7) comprises a first region (71) and a second region (72), the curvature of the first region being less than the curvature of the second region.

15. Illumination device according to at least one of the previous claims, that
the optoelectronic component (20), in particular the housing body, has at least one fixing device (201) and the fixing element (9) for fixing the optical element (2) engages in the fixing device of the optoelectronic component (20).

16. Illumination device according to at least one of the previous claims,
**characterized in that**
the optical element (2) is provided for fixing at the optoelectronic component (20) by means of press fit, hot press fit, caulking, hot caulking, thermal riveting or adhesive bonding.

17. Illumination device according to at least one of the previous claims,
**characterized in that**
the guide element (10) is embodied in bevelled fashion on a side remote from the edge (13).

18. Illumination device according to at least one of the previous claims, that
the optical element (2) comprises a plurality of fixing elements (9) and guide elements (10) and the number of the guide elements is greater than the number of the fixing elements.

19. Illumination device according to at least one of the previous claims,
**characterized in that**
an intermediate layer (14) is arranged between the optical element (2) fixed at the optoelectronic component (20) and the semiconductor chip (3).

20. Illumination device according to claim 19,
**characterized in that**
the intermediate layer (14) is plastically shapeable.

21. Illumination device according to claim 19 or 20, **characterized in that**
the intermediate layer (14) contains a silicone, in particular a silicone gel.

22. Illumination device according to at least one of the previous claims,
**characterized in that**
an intermediate space (15) is formed between the optical element (2) fixed at the optoelectronic component (20) and the optoelectronic component, in particular between the side of the housing body which faces the optical element (2) and the radiation entrance surface.

23. Illumination device according to claims 19 and 22, **characterized in that**
the intermediate space (15) is provided as a gap for receiving the intermediate layer in the event of an expansion of the intermediate layer (14).

24. Illumination device according to at least one of the previous claims,
**characterized in that**
the semiconductor chip (3) is embedded in an encapsulation (210) .

25. Illumination device according to claims 19 and 24, **characterized in that**
the intermediate layer (14) adjoins the encapsulation (210) and the optical element (2).

26. Illumination device according to at least one of the claims 19 to 21, 23 and 25,
**characterized in that**
the intermediate layer (14) is formed as a refractive index adaption layer.

27. Illumination device according to at least one of the previous claims,
**characterized in that**
the illumination device (1) is provided for backlighting of a display device, such as an LCD.

## Revendications

1. Dispositif d'éclairage (1) comprenant
un composant optoélectronique (20) présentant un corps de boîtier (203) et au moins une puce semi-conductrice (3) prévue pour générer un rayonnement,
et un élément optique séparé (2) prévu pour être fixé au composant optoélectronique et présentant un axe optique, l'élément optique présentant une surface de sortie de rayonnement (4),
**caractérisé en ce que**
- la surface de sortie de rayonnement présente une zone partielle concave (5) et une zone partielle convexe (7) entourant au moins partiellement la zone partielle concave à une distance de l'axe optique, l'axe optique (6) traversant la zone partielle concave,
- l'élément optique (2) présente au moins un élément de fixation (9) et l'élément de fixation est prévu pour fixer l'élément optique sur le composant optoélectronique (20),
- l'élément optique (2) comprend au moins un élément de guidage (10) qui, par rapport à l'élément de fixation, est disposé plus près d'un bord (13) délimitant l'élément optique (2) du côté de l'élément de fixation,
- l'élément de guidage (10) est disposé à l'extérieur du corps de boîtier (203) et s'étend verticalement le long d'une surface latérale du corps de boîtier (203).

2. Dispositif d'éclairage selon la revendication 1, **caractérisé en ce que**
l'axe optique (6) de l'élément optique (2) fixé au composant optoélectronique (20) traverse la puce semi-conductrice (3).

3. Dispositif d'éclairage selon au moins l'une des revendications précédentes,
**caractérisé en ce que**
l'élément optique (2) est symétrique en rotation par rapport à l'axe optique (6).

4. Dispositif d'éclairage selon au moins l'une des revendications précédentes,
**caractérisé en ce que**
la zone partielle convexe (7) présente une courbure inférieure à une courbure de la zone partielle concave (5).

5. Dispositif d'éclairage selon au moins l'une des revendications précédentes,
**caractérisé en ce que**
la zone partielle convexe (7) présente une surface supérieure à la surface de la zone partielle concave (5).

6. Dispositif d'éclairage selon au moins l'une des revendications précédentes,
**caractérisé en ce que**
le corps du boîtier (203) est préfabriqué et la puce semi-conductrice (3) est placée ultérieurement sur le corps du boîtier.

7. Dispositif d'éclairage selon au moins l'une des revendications précédentes,
**caractérisé en ce que**
le composant optoélectronique (20) présente une grille de connexion remodelée, en particulier avec le corps du boîtier (203) .

8. Dispositif d'éclairage selon au moins l'une des revendications précédentes,
**caractérisé en ce que**
le composant optoélectronique (20), en particulier la grille de connexion, comporte un premier connecteur électrique (205), un deuxième connecteur électrique (206) et un connecteur thermique (215).

9. Dispositif d'éclairage selon au moins l'une des revendications précédentes,
**caractérisé en ce que**
le composant optoélectronique (20) est conçu en tant que composant montable en surface.

10. Dispositif d'éclairage selon au moins une des revendications précédentes,
**caractérisé en ce que**
la puce semi-conductrice (3) comprend un corps semi-conducteur (302) disposé sur un support (301) et le corps semi-conducteur présente une succession de couches semi-conductrices.

11. Dispositif d'éclairage selon la revendication 10, **caractérisé en ce que**
le support (301) est différent d'un substrat de croissance pour la succession de couches semi-conductrices.

12. Dispositif d'éclairage selon la revendication 10 ou 11, **caractérisé en ce que**
une couche miroir (306) est disposée sur le corps semi-conducteur (302), en particulier entre le corps semi-conducteur et le support (301).

13. Dispositif d'éclairage selon la revendication 12, **caractérisé en ce que**
la couche miroir (306) contient un métal.

14. Dispositif d'éclairage selon au moins l'une des revendications précédentes,
**caractérisé en ce que** la zone partielle convexe (7) comprend une première zone (71) et une deuxième zone (72), la courbure de la première zone étant inférieure à la courbure de la deuxième zone.

15. Dispositif d'éclairage selon au moins l'une des revendications précédentes,
**caractérisé en ce que**
le composant optoélectronique (20), en particulier le corps du boîtier, présente au moins un dispositif de fixation (201) et l'élément de fixation (9) destiné à fixer l'élément optique (2) s'engage dans le dispositif de fixation du composant optoélectronique (20).

16. Dispositif d'éclairage selon au moins l'une des revendications précédentes,
**caractérisé en ce que**
l'élément optique (2) est prévu pour la fixation sur le composant optoélectronique (20) au moyen d'un ajustage serré, d'un ajustement serré à chaud, d'un calfeutrage, d'un calfeutrage à chaud, d'un rivetage thermique ou d'un adhésif.

17. Dispositif d'éclairage selon au moins l'une des revendications précédentes,
**caractérisé en ce que**
l'élément de guidage (10) est biseauté sur un côté opposé au bord (13).

18. Dispositif d'éclairage selon au moins l'une des revendications précédentes,
**caractérisé en ce que**
l'élément optique (2) présente une pluralité d'éléments de fixation (9) et d'éléments de guidage (10) et le nombre des éléments de guidage est supérieur au nombre des éléments de fixation.

19. Dispositif d'éclairage selon au moins l'une des revendications précédentes,
**caractérisé en ce que**
une couche intermédiaire (14) est disposée entre l'élément optique (2) fixé au composant optoélectronique (20) et la puce semi-conductrice (3).

20. Dispositif d'éclairage selon la revendication 19, **caractérisé en ce que**
la couche intermédiaire (14) est déformable plastiquement.

21. Dispositif d'éclairage selon la revendication 19 ou 20, **caractérisé en ce que**
la couche intermédiaire (14) contient un silicone, en particulier un gel de silicone.

22. Dispositif d'éclairage selon au moins l'une des revendications précédentes,
**caractérisé en ce que**
un espace intermédiaire (15) est formé entre l'élément optique (2) fixé au composant optoélectronique (20) et le composant optoélectronique, en particulier entre le côté du corps du boîtier dirigé vers l'élément optique (2) et la surface d'entrée du rayonnement.

23. Dispositif d'éclairage selon les revendications 19 et 22, **caractérisé en ce que**
l'espace intermédiaire (15) est prévu en tant que joint permettant de recevoir la couche intermédiaire lorsque la couche intermédiaire (14) se dilate.

24. Dispositif d'éclairage selon au moins l'une des revendications précédentes,
**caractérisé en ce que**
la puce semi-conductrice (3) est incorporée dans une enveloppe (210).

25. Dispositif d'éclairage selon les revendications 19 et 24, **caractérisé en ce que**
la couche intermédiaire (14) est adjacente à l'enveloppe (210) et à l'élément optique (2).

26. Dispositif d'éclairage selon au moins l'une des revendications 19 à 21, 23 et 25,
**caractérisé en ce que**
la couche intermédiaire (14) est formée en tant que couche d'adaptation d'indice de réfraction.

27. Dispositif d'éclairage selon au moins l'une des revendications précédentes,
**caractérisé en ce que**
le dispositif d'éclairage (1) est prévu pour le rétroéclairage d'un dispositif d'affichage, tel qu'un écran LCD.
